# EUROPÄISCHE PATENTSCHRIFT

(11) **EP 2 430 889 B1**
(45) Veröffentlichungstag und Bekanntmachung des Hinweises auf die Patenterteilung: **30.04.2014**
(21) Anmeldenummer: 10721984.2
(22) Anmeldetag: 12.05.2010
(51) Int. Cl.: H05K 3/00, C25D 7/06, C25D 17/00, C25D 21/10

(54) **VERFAHREN, BEHANDLUNGSSTATION UND ANLAGE ZUM BEHANDELN VON FLÄCHIGEM BEHANDLUNGSGUT**
METHOD, TREATMENT STATION, AND SYSTEM FOR THE TREATMENT OF FLAT FEEDSTOCK
PROCÉDÉ, STATION DE TRAITEMENT ET INSTALLATION POUR LE TRAITEMENT D'UN PRODUIT À TRAITER PLAT

(30) Priorität: 13.05.2009 DE 102009021042
(43) Veröffentlichungstag der Anmeldung: 21.03.2012
(73) Patentinhaber: Atotech Deutschland GmbH, 10553 Berlin (DE)
(72) Erfinder: KUNZE, Henry, 90530 Wendelstein (DE)
(74) Vertreter: Meier, Florian
(86) Internationale Anmeldenummer: PCT/EP2010/002938
(87) Internationale Veröffentlichungsnummer: WO 2010/130444

(56) Entgegenhaltungen:
- DE-A1- 3 603 856
- DE-A1- 19 519 211
- DE-B3- 10 358 149
- DE-C1- 10 206 660

## Beschreibung

Die Erfindung betrifft ein Verfahren, eine Behandlungsstation und eine Anlage zum Behandeln von flächigem Behandlungsgut. Insbesondere betrifft die Erfindung derartige Verfahren, Behandlungsstationen und Anlagen , die eine Behandlung von Behandlungsgut mit einer empfindlichen Oberfläche oder mehreren empfindlichen Oberflächen erlauben. Die Erfindung betrifft auch derartige Verfahren, Behandlungsstationen und Anlagen, bei denen eine Berührung zwischen einem zu behandelnden Nutzbereich des Behandlungsgutes und festen Elementen reduziert werden kann.

Bei der Bearbeitung von flächigem Behandlungsgut, wie beispielsweise Leiterplatten in der Leiterplattenindustrie, findet eine Behandlung des Behandlungsgutes häufig in einer nasschemischen Prozesslinie statt. Um Behandlungsflüssigkeit, wie eine Prozesschemikalie oder Wasser, zu entfernen, können so genannte Abquetschwalzen verwendet werden. Derartige Walzen können beispielsweise eingesetzt werden, um ein Anstauen von Behandlungsflüssigkeit für eine Tauchbehandlung in einer Behandlungsstation vorzunehmen, wie dies in der DE 43 37 988 A1 beschrieben ist. Zur Verbesserung des Stoffaustausches an der Substratoberfläche können Düsen eingesetzt werden, um die Oberfläche des Behandlungsgutes mit einem Fluid anzuströmen.

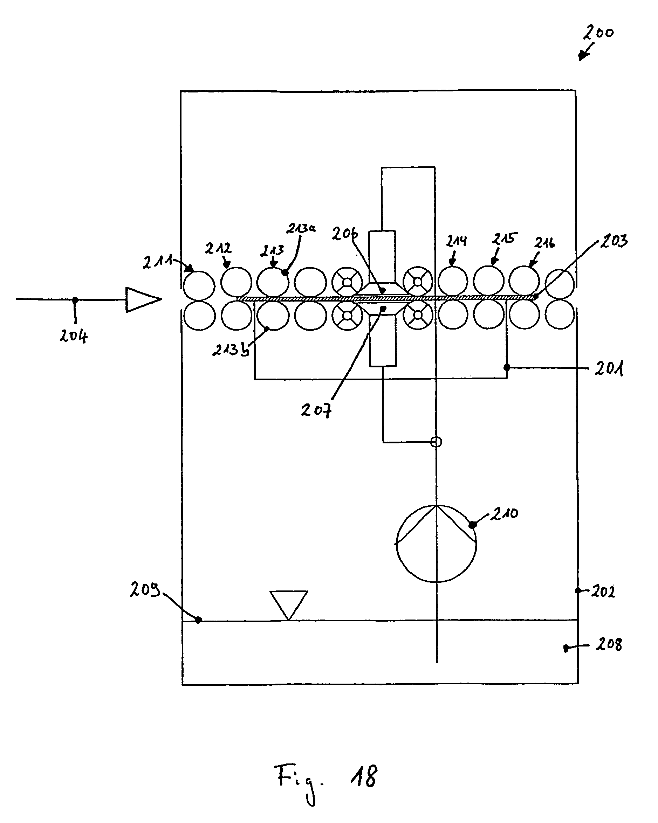

Fig. 18 ist eine schematische Darstellung einer Behandlungsstation 200, in der das Flüssigkeitsniveau der Behandlungsflüssigkeit höher als eine Transportebene des Behandlungsgutes 203 ist, so dass das Behandlungsgut 203 eingetaucht transportiert werden kann. Das Behandlungsgut 203 wird in einer horizontalen Transportrichtung 204 durch die Behandlungsstation transportiert. Zum Transportieren des Behandlungsgutes sind Walzenpaare 211-216 vorgesehen, die in Anlage mit den nach oben bzw. unten zeigenden Oberflächen des Behandlungsgutes 203 kommen, um dieses zu transportieren. Um das Auslaufen der Behandlungsflüssigkeit zu vermeiden, ist ein Innenbehälter 201 vorgesehen, in dem die Behandlungsflüssigkeit auf das (nicht dargestellte) hohe Niveau angestaut ist. Der Innenbehälter 201 wird von einem Außenbehälter 202 so umfangen, dass der Außenbehälter 202 die aus dem Innenbehälter 201 überströmende Behandlungsflüssigkeit auffängt. Von der im Außenbehälter 202 aufgefangenen Behandlungsflüssigkeit 208, die im Außenbehälter ein Niveau 209 aufweist, wird die Behandlungsflüssigkeit mit einer Pumpe 210 zurück in den Innenbehälter 201 gepumpt. Die Behandlungsflüssigkeit kann über Anströmdüsen 206, 207 oder einem anderen Behandlungsorgan zurück in den Innenbehälter 201 abgegeben werden.

Zum Anstauen der Behandlungsflüssigkeit in dem Innenbehälter 201 werden Paare von so genannten Abquetschwalzen 213, 215 im Ein- und Auslaufbereich des Innenbehälters 201 verwendet. Die Paare von Abquetschwalzen 213, 215 können beispielsweise eine zylinderförmige Mantelfläche aufweisen. Wenn die Abquetschwalzen 213a, 213b des Paares 213 und die Abquetschwalzen des Walzenpaares 215 an dem Behandlungsgut 203 anliegen, wird der freie Querschnitt, durch welchen die Behandlungsflüssigkeit aus dem Innenbehälter 201 austreten kann, eingeschränkt. Durch entsprechende Einstellung der Förderleistung der Pumpe 210 kann ein gewünschtes Niveau der Behandlungsflüssigkeit im Innenbehälter 201 eingestellt werden. Zusätzliche Walzenpaare, wie die Walzenpaare 211, 212, 214 und 216 im Ein- oder Auslaufbereich des Behandlungsstation können ebenfalls als Abquetschwalzen wirken.

Falls das Behandlungsgut 203 eine oder mehrere empfindliche Oberflächen aufweist, kann jedoch der direkte Kontakt zwischen den Abquetschwalzenpaaren 213, 215 und dem Behandlungsgut 203, der bei herkömmlichen Abquetschwalzen über die gesamte Breite, d.h. die gesamte Ausdehnung quer zur Transportrichtung 204, des Behandlungsgutes 203 besteht, zu Schäden an der Oberfläche des Behandlungsgutes 203 führen. Schäden an den Oberflächen des Behandlungsgutes 203 können beispielsweise durch die Flächenpressung oder an den Oberflächen der Abquetschwalzen 213, 215 anhaftende Partikel und Oberflächenunebenheiten hervorgerufen werden. Darüber hinaus kann es im Bereich der Anströmdüsen 206, 207 zu unerwünschten Auslenkungen des Behandlungsgutes 203 kommen, beispielsweise durch die Strömungsverhältnisse in der Behandlungsstation. Die Auslenkungen können das Behandlungsgut 203 in Kontakt mit anderen Elementen der Behandlungsstation bringen.

Die DE 36 03 856 A1, die als Grundlage für den Oberbegriff der unabhängigen Ansprüche dient, beschreibt ein Verfahren und eine Vorrichtung zur Galvanisierung. Die Vorrichtung weist ein kathodisch geschaltetes Walzenpaar auf, das ein Werkstück erfasst und transportiert. Die Vorrichtung weist ein anodisch geschaltetes Walzenpaar auf, das ebenfalls rotierend gelagert ist und das sich mit einer Umdrehungszahl dreht, die größer als die Umdrehungszahl des kathodisch geschalteten Walzenpaars ist. Elektrolyt wird dem anodisch geschalteten Walzenpaar über ein Anspritzregister zugeführt.

Die DE 195 19 211 A1 beschreibt eine Behandlungsvorrichtung, bei der eine Behandlungsflüssigkeit angestaut wird. Walzen dienen sowohl zum Transport des Behandlungsgutes als auch zum Bilden eines Flüssigkeits-Leitraumes, mit dem Gebiete unterschiedlichen Drucks erzeugt werden.

Der Erfindung liegt die Aufgabe zugrunde, ein Verfahren, eine Behandlungsstation und eine Anlage zum Behandeln von flächigem Behandlungsgut anzugeben, bei dem bzw. bei der die Gefahr einer Beschädigung empfindlicher Oberflächen des Behandlungsgutes verringert werden kann. Der Erfindung liegt auch die Aufgabe zugrunde, ein Verfahren zur Herstellung von Leiterplatten anzugeben, bei dem die Gefahr einer Beschädigung empfindlicher Oberflächenbereiche der Leiterplatte verringert werden kann.

Erfindungsgemäß wird die Aufgabe gelöst durch ein Verfahren, eine Behandlungsstation und eine Anlage zum Behandeln von flächigem Behandlungsgut, wie sie in den unabhängigen Ansprüchen angegeben sind. Die abhängigen Ansprüche definieren bevorzugte und vorteilhafte Ausführungsformen der Erfindung.

Nach einem Aspekt wird ein Verfahren zum Behandeln eines flächigen Behandlungsgutes, das durch eine Anlage zur elektrolytischen oder nasschemischen Behandlung des Behandlungsgutes transportiert wird, angegeben. Das Behandlungsgut wird in einer Behandlungsstation der Anlage einer Behandlungsflüssigkeit ausgesetzt, die das Behandlungsgut überdeckt. In der Behandlungsstation ist eine Walze mit einer Walzenoberfläche derart positioniert ist, dass die Walzenoberfläche wenigstens von einem Nutzbereich des Behandlungsgutes, der sich kontinuierlich zwischen Randbereichen des Behandlungsgutes erstreckt, beabstandet ist, so dass zwischen der Walzenoberfläche und dem Nutzbereich des Behandlungsgutes ein Spalt freibleibt. Die Walzenoberfläche ist wenigstens teilweise in der Behandlungsflüssigkeit angeordnet. Die Walze wird derart drehend angetrieben, dass an dem Spalt eine Relativgeschwindigkeit zwischen der Walzenoberfläche und einer Oberfläche des Behandlungsgutes hervorgerufen wird.

Das Risiko einer Beschädigung der Oberfläche des Behandlungsgutes kann bei dem Verfahren vermindert werden, da ein sich zwischen der Walze und dem Nutzbereich des Behandlungsgutes erstreckender Spalt vorgesehen ist. Bei einer Ausgestaltung kann die Walze von dem gesamten Behandlungsgut beabstandet sein. Durch die Relativgeschwindigkeit an den entgegengesetzten Seiten des Spaltes kann der Stoffaustausch an einer Oberfläche des Behandlungsgutes gefördert und/oder ein Austritt von Behandlungsflüssigkeit durch den Spalt reduziert werden.

Der freibleibende Spalt zwischen der Walzenoberfläche und dem Nutzbereich des Behandlungsgutes kann durch die Geometrie der Anlage vorgegeben sein oder sich, insbesondere bei Behandlungsgut mit geringer Eigensteifigkeit, aus einem Kräftegteichwicht ergeben.

Der Teil der Walzenoberfläche, der um die Spalthöhe von der Oberfläche des Behandlungsgutes beabstandet ist, kann sich mit einer Geschwindigkeit bewegen, die sich in Richtung und/oder Betrag von einer Transportgeschwindigkeit des Behandlungsgutes unterscheidet.

Die Walze kann so angetrieben wird, dass sich der den Spalt begrenzende Teil der Walzenoberfläche entgegengesetzt zu einer Transportrichtung des Behandlungsgutes bewegt. Dadurch kann eine Relativgeschwindigkeit an dem Spalt realisiert werden, ohne dass die Walze mit hoher Drehzahl rotieren muss.

Die Walze ist vorteilhaft so angeordnet, dass ihre Rotationsachse parallel zu einer Transportebene des Behandlungsgutes ist.

Die Walze kann so angetrieben werden, dass ein Betrag einer Umfangsgeschwindigkeit der Walzenoberfläche von einem Betrag der Transportgeschwindigkeit des Behandlungsgutes verschieden, insbesondere größer als der Betrag der Transportgeschwindigkeit ist. In diesem Fall kann sich der Teil der Walzenoberfläche, der um die Spalthöhe von der Oberfläche des Behandlungsgutes beabstandet ist, in Transportrichtung des Behandlungsgutes bewegen.

Mit einer Abstreifeinrichtung kann Behandlungsflüssigkeit von der Walze entfernt werden. Die Abstreifeinrichtung kann verstellt werden, um eine Menge der Behandlungsflüssigkeit einzustellen, die von der Walze entfernt wird. Auf diese Weise kann kontrolliert werden, wie stark der durch die Walze hervorgerufene Stoffaustausch ist bzw. wie stark ein Flüssigkeitsaustritt durch den Spalt reduziert wird.

Die Abstreifeinrichtung kann so angeordnet werden, dass sie einen gleichmäßigen Abstand von der Walzenoberfläche aufweist. Dadurch kann eine gleichmäßige Wirkung über die Walze in Axialrichtung erzielt werden. Der Abstand zwischen der Abstreifeinrichtung und der Walzenoberfläche kann einstellbar sein. Beispielsweise kann die Abstreifeinrichtung als Leiste ausgebildet sein, die sich parallel zu der Achse der Walze erstreckt und in verschiedenen Abständen von der Walzenoberfläche positioniert werden kann.

Die Walze kann als Behandlungsorgan in der Behandlungsstation vorgesehen sein. Dies erlaubt es, die Walze beispielsweise anstelle einer Anströmdüse vorzusehen. Durch die Verwendung der Walze als Behandlungsorgan kann eine Behandlungsstation mit geringeren Baumaßen realisiert werden. Entsprechend kann eine Kostenersparnis erzielt werden. Auch können die auf das Behandlungsgut wirkenden Kräfte reduziert werden. Energiekosten können verringert werden. Auch kann eine Schonung des Behandlungsbades erreicht werden.

Wenn die Walze als Behandlungsorgan dient, kann die minimale Spalthöhe zwischen der Walzenoberfläche und dem Nutzbereich des Behandlungsgutes kleiner als 1 mm, insbesondere kleiner als 0,7 mm, insbesondere kleiner als 0,5 mm sein. Die minimale Spalthöhe kann mindestens 0,05 mm, insbesondere mindestens 0,07 mm, insbesondere mindestens 0,09 mm betragen. Die minimale Spalthöhe kann auch größer als die genannte Grenzwerte sein, sollte jedoch typischerweise kleiner als 10,0 mm sein.

Die Walze kann derart angeordnet sein, dass durch die Relativgeschwindigkeit zwischen der Walzenoberfläche und der Oberfläche des Behandlungsgutes ein Stoffaustausch an einer zu behandelnden Oberfläche des Behandlungsgutes erhöht wird. Insbesondere kann die Walze derart angeordnet sein, dass sich durch die Drehung der Walze eine Wirkung auf die Behandlungsflüssigkeit an der Oberfläche bzw. in Bohrlöchern des Behandlungsgutes ergibt.

An in Transportrichtung entgegengesetzten Seiten der Walze kann die Behandlungsflüssigkeit bis zu einem Betriebsniveau der Behandlungsstation an der Walze anstehen. Die Walze kann auch vollständig unterhalb des Betriebsniveaus der Behandlungsstation angeordnet sein. Dies erlaubt den Einsatz der Walze als Behandlungsorgan in einem Abschnitt der Behandlungsstation, der von dem Einlaufbereich und dem Auslaufbereich beabstandet sein kann.

Die Walze kann auch in einem Einlaufbereich oder in einem Auslaufbereich der Behandlungsstation vorgesehen sein. Beispielsweise kann die Walze in einer Umgebung eines Randes eines Innenbehälters der Behandlungsstation vorgesehen sein. Die Walzenoberfläche bildet in diesem Fall eine Rückhaltefläche zum Zurückhalten der Behandlungsflüssigkeit aus. Der Austritt von Behandlungsflüssigkeit durch den Spalt kann aufgrund der Relativbewegung am Spalt vermindert werden.

Wenn die Walzenoberfläche als Rückhaltefläche dient, kann die minimale Spalthöhe zwischen der Walzenoberfläche und dem Nutzbereich des Behandlungsgutes kleiner als 1 mm, insbesondere kleiner als 0,7 mm, insbesondere kleiner als 0,5 mm sein. Die minimale Spalthöhe kann mindestens 0,05 mm, insbesondere mindestens 0,07 mm, insbesondere mindestens 0,09 mm betragen.

Eine weitere Walze mit einer weiteren Walzenoberfläche kann derart positioniert sein, dass ein weiterer Spalt zwischen dem Nutzbereich des Behandlungsgutes und der weiteren Walzenoberfläche freibleibt. Die Walze und die weitere Walze können an entgegengesetzten Seiten einer Transportebene des Behandlungsgutes angeordnet sein. Beispielsweise können die Walze und die weitere Walze derart angeordnet sein, dass ihre Achsen an in Transportrichtung gleichen Positionen angeordnet sind. Bei weiteren Ausgestaltungen können die Achsen der Walze und der weiteren Walze in Transportrichtung beabstandet sein. Durch das Vorsehen der weiteren Walze kann die Behandlung des Behandlungsgutes weiter verbessert und/oder der Austritt von Behandlungsflüssigkeit weiter vermindert werden.

Die weitere Walze kann derart drehend angetrieben werden, dass sich ein Teil der weiteren Walzenoberfläche, der einen Rand des weiteren Spaltes ausbildet, eine in die Transportrichtung gerichtete Geschwindigkeit aufweist. Der Betrag der Umfangsgeschwindigkeit der weiteren Walze kann gleich dem Betrag der Transportgeschwindigkeit ± 20% sein. Dadurch kann der Transport von Behandlungsgut mit geringer Eigensteifigkeit vorteilhaft beeinflusst werden.

Die weitere Walze kann derart drehend angetrieben wird, dass sich die Walze und die weitere Walze gleichsinnig drehen.

Nach einem weiteren Aspekt wird eine Behandlungsstation zum Behandeln eines flächigen Behandlungsgutes für eine Anlage zur elektrolytischen oder nasschemischen Behandlung des Behandlungsgutes angegeben. Die Behandlungsstation ist derart eingerichtet, dass im Betrieb eine Behandlungsflüssigkeit das zu behandelnde Behandlungsgut überdeckt. Die Behandlungsstation umfasst eine Walze mit einer Walzenoberfläche, die derart angeordnet ist, dass die Walzenoberfläche wenigstens von einem Nutzbereich des Behandlungsgutes, der sich kontinuierlich zwischen Randbereichen des Behandlungsgutes erstreckt, beabstandet ist, so dass zwischen der Walzenoberfläche und dem Nutzbereich des Behandlungsgutes ein Spalt freibleibt. Die Walze ist weiterhin derart angeordnet, dass die Walzenoberfläche wenigstens teilweise in der Behandlungsflüssigkeit angeordnet ist. Eine Antriebseinrichtung ist eingerichtet, um die Walze derart drehend anzutreiben, dass an dem Spalt eine Relativgeschwindigkeit zwischen der Walzenoberfläche und der Oberfläche des Behandlungsgutes resultiert.

Das Risiko einer Beschädigung der Oberfläche des Behandlungsgutes kann bei der Behandlungsstation vermindert werden, da ein sich zwischen der Walze und dem Nutzbereich des Behandlungsgutes erstreckender Spalt vorgesehen ist. Bei einer Ausgestaltung kann die Walze von dem gesamten Behandlungsgut beabstandet sein. Durch die Relativgeschwindigkeit an den entgegengesetzten Kanten des Spaltes kann der Stoffaustausch an einer Oberfläche des Behandlungsgutes gefördert und/oder ein Austritt von Behandlungsflüssigkeit durch den Spalt reduziert werden.

Die Antriebseinrichtung kann eingerichtet sein, um die Walze derart drehend anzutreiben, dass sich der den Spalt begrenzende Teil der Walzenoberfläche entgegengesetzt zu einer Transportrichtung des Behandlungsgutes bewegt.

Die Antriebseinrichtung kann eingerichtet sein, um die Walze derart drehend anzutreiben, dass ein Betrag einer Umfangsgeschwindigkeit der Walzenoberfläche von einem Betrag der Transportgeschwindigkeit des Behandlungsgutes verschieden, insbesondere größer als der Betrag der Transportgeschwindigkeit, ist.

Die Walze ist vorteilhaft so angeordnet, dass ihre Rotationsachse parallel zu einer Transportebene des Behandlungsgutes ist.

Die Behandlungsstation kann eine Abstreifeinrichtung, insbesondere eine relativ zu der Walze verstellbare Abstreifeinrichtung, zum Entfernen von Behandlungsflüssigkeit von der Walze umfassen.

Die Walze kann als Behandlungsorgan in der Behandlungsstation vorgesehen sein. An in Transportrichtung entgegengesetzten Seiten der Walze kann die Behandlungsflüssigkeit bis zu einem Betriebsniveau der Behandlungsstation an der Walze anstehen, oder die Walze kann vollständig unterhalb des Betriebsniveaus der Behandlungsstation angeordnet sein.

Die Walze kann in einem Einlaufbereich oder in einem Auslaufbereich der Behandlungsstation vorgesehen sein, wobei die Walzenoberfläche als Rückhaltefläche zum Zurückhalten der Behandlungsflüssigkeit ausgebildet ist. Die Walze kann beispielsweise an einem Rand eines Innenbereichs der Behandlungsstation vorgesehen sein.

Die Behandlungsstation kann eine weitere Walze mit einer weiteren Walzenoberfläche umfassen, die derart positioniert ist, dass ein weiterer Spalt zwischen dem Nutzbereich des Behandlungsgutes und der weiteren Walzenoberfläche freibleibt. Die Walze und die weitere Walze können an entgegengesetzten Seiten einer Transportebene des Behandlungsgutes angeordnet sein.

Die Antriebseinrichtung kann eingerichtet sein, um die weitere Walze derart drehend anzutreiben, dass sich ein Teil der weiteren Walzenoberfläche, der einen Rand des weiteren Spaltes ausbildet, in der Transportrichtung dreht. Die Umfangsgeschwindigkeit der weiteren Walze kann gleich der Transportgeschwindigkeit sein.

Die Antriebseinrichtung kann eingerichtet sein, um die weitere Walze derart drehend anzutreiben, dass sich die weitere Walze und die Walze gleichsinnig drehen.

Die Behandlungsstation kann so ausgestaltet sein, dass sie zur Durchführung des Verfahrens nach einer der beschriebenen Ausführungsformen oder einem der Ausführungsbeispiele eingerichtet ist.

Die Behandlungsstation kann weiterhin mehrere Transportelemente zum Transportieren des Behandlungsgutes umfassen, die beispielsweise als Transportwalzen oder Transportrollen ausgebildet sein können.

Die Wirkungen der Weiterbildungen der Behandlungsstation entsprechen den Wirkungen der entsprechenden Weiterbildungen des Verfahrens.

Nach einem weiteren Aspekt wird eine Anlage zum Behandeln eines flächigen Behandlungsgutes angegeben, die die Behandlungsstation nach einer Ausführungsform oder einem Ausführungsbeispiel umfasst.

Nach einem weiteren Aspekt wird ein Verfahren zum Herstellen einer Leiterplatte angegeben, bei dem ein Material zur Herstellung der Leiterplatte mit dem Verfahren nach nach einer Ausführungsform oder einem Ausführungsbeispiel behandelt wird.

Ausführungsbeispiele der Erfindung erlauben es, in einer Anlage zur elektrolytischen oder nasschemischen Behandlung eines Behandlungsgutes eine Behandlungsflüssigkeit von dem Behandlungsgut zu entfernen oder abzuhalten oder den Stoffaustausch an der Oberfläche des Behandlungsgutes zu fördern. Dabei kann eine Walzenoberfläche beabstandet zu einem Nutzbereich des Behandlungsgutes so angeordnet werden, dass ein Spalt ausgebildet ist, um einen direkten Kontakt des Nutzbereichs mit einem festen Element zu verringern oder zu vermeiden.

Ausführungsbeispiele der Erfindung können insbesondere in Anlagen eingesetzt werden, in denen flächiges Behandlungsgut mit einer empfindlichen Oberfläche in einer horizontalen oder im Wesentlichen in einer horizontalen Transportebene transportiert wird. Jedoch sind die Ausführungsbeispiele nicht auf dieses Anwendungsgebiet beschränkt.

Die Erfindung wird nachfolgend anhand bevorzugter oder vorteilhafter Ausführungsbeispiele unter Bezugnahme auf die beigefügten Zeichnungen näher erläutert.
Fig. 1 ist eine schematische Vorderansicht einer Vorrichtung zum Entfernen oder Abhalten von Behandlungsflüssigkeit einer Behandlungsstation nach einem Ausführungsbeispiel.
Fig. 2 ist eine schematische, teilweise geschnittene Seitenansicht der Vorrichtung von Fig. 1.
Fig. 3 ist eine schematische, teilweise geschnittene Seitenansicht einer Vorrichtung zum Entfernen von Behandlungsflüssigkeit einer Behandlungsstation nach einem weiteren Ausführungsbeispiel.
Fig. 4 ist eine schematische, teilweise geschnittene Seitenansicht eines Abschnitts einer Behandlungsstation mit mehreren Vorrichtungen zum Entfernen von Behandlungsflüssigkeit nach einem Ausführungsbeispiel.
Fig. 5 ist eine schematische, teilweise geschnittene Seitenansicht eines Abschnitts einer Behandlungsstation mit mehreren Vorrichtungen zum Entfernen von Behandlungsflüssigkeit nach einem weiteren Ausführungsbeispiel.
Fig. 6 ist eine schematische Vorderansicht einer Vorrichtung zum Entfernen oder Abhalten von Behandlungsflüssigkeit einer Behandlungsstation nach einem weiteren Ausführungsbeispiel.
Fig. 7 ist eine schematische, teilweise geschnittene Seitenansicht einer Vorrichtung zum Entfernen von Behandlungsflüssigkeit.
Fig. 8 ist eine schematische, teilweise geschnittene Seitenansicht einer Behandlungsstation mit Vorrichtungen zum Entfernen oder Abhalten von Behandlungsflüssigkeit nach einem Ausführungsbeispiel in einem Ein- und Auslaufbereich.
Fig. 9 ist eine schematische, teilweise geschnittene Seitenansicht eines Auslaufbereichs einer Behandlungsstation nach einem weiteren Ausführungsbeispiel.
Fig. 10 ist eine schematische, teilweise geschnittene Seitenansicht eines Auslaufbereichs einer Behandlungsstation nach einem weiteren Ausführungsbeispiel.
Fig. 11-17 sind jeweils schematische, teilweise geschnittene Seitenansichten eines mit einer Walze ausgebildeten Behandlungsorgans einer Behandlungsstation nach weiteren Ausführungsbeispielen.
Fig. 18 ist eine schematische, teilweise geschnittene Seitenansicht einer Behandlungsstation mit Abquetschwalzenpaaren.

Richtungs- oder Positionsangaben, die sich auf das Behandlungsgut beziehen, werden konventionsgemäß in Bezug auf die Transportrichtung angegeben. Die Richtung, die beim Transportieren des Behandlungsgutes parallel bzw. antiparallel zur Transportrichtung ist, wird als Längsrichtung, die in der Transportebene liegende Richtung orthogonal zur Transportrichtung als Breitenrichtung des Behandlungsgutes bezeichnet.

Es werden Ausführungsbeispiele von Vorrichtungen und Verfahren beschrieben, bei denen Behandlungsflüssigkeit von einem Behandlungsgut abgehalten oder entfernt, und/oder bei denen der Stoffaustausch an dem Behandlungsgut gefördert wird. Unter Behandlungsflüssigkeit wird jede Flüssigkeit verstanden, der das Behandlungsgut in einer Anlage zur elektrolytischen oder nasschemischen Behandlung ausgesetzt werden kann, insbesondere eine Prozesschemikalie, eine Spülflüssigkeit wie Wasser oder dergleichen.

Die Ausführungsbeispiele werden im Kontext einer Anlage zum Behandeln von Behandlungsgut beschrieben, bei der das Behandlungsgut in einer horizontalen Transportebene transportiert wird. Angaben wie "oberhalb der Transportebene" oder "unterhalb der Transportebene", "obere Oberfläche", "untere Oberfläche" sowie Bezugnahmen auf eine Höhe oder ein Niveau von Behandlungsflüssigkeit und dergleichen sind entsprechend auf die Vertikalrichtung bezogen, sofern dies nicht anderweitig angegeben ist. Unter einem Transport in einer horizontalen Transportebene kann dabei insbesondere ein Transport von Behandlungsgut verstanden werden, bei dem wenigstens drei Ecken des Behandlungsgutes in einer horizontalen Ebene liegen. Dies schließt nicht aus, dass zumindest einzelne Abschnitt oder Bereiche des Behandlungsgutes beim Transportieren außerhalb der Transportebene liegen, beispielsweise bei einem Behandlungsgut mit geringer Eigensteifigkeit.

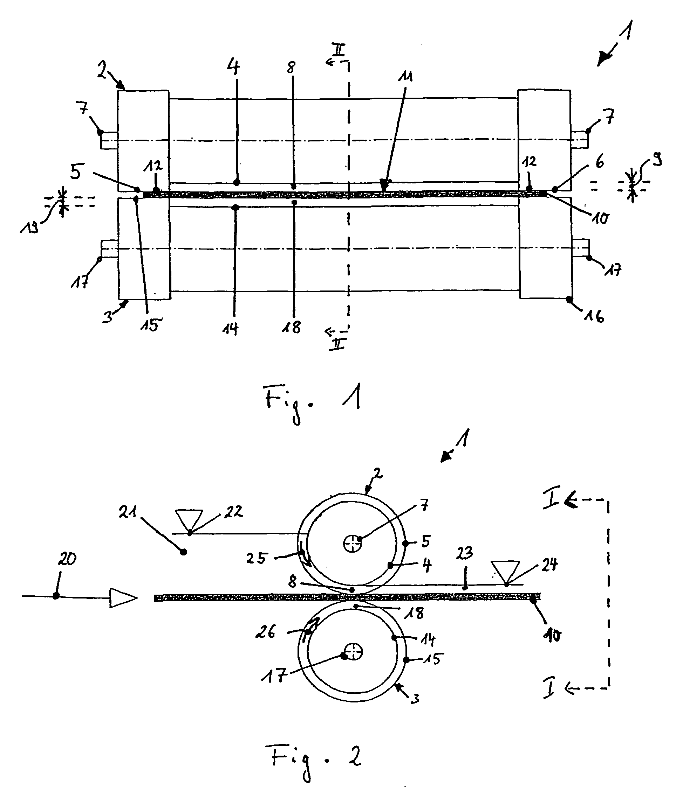

Fig. 1 ist eine schematische Vorderansicht einer Vorrichtung 1 zum Entfernen von Behandlungsflüssigkeit von einem Behandlungsgut 10. Fig. 2 ist eine schematische Seitenansicht der Vorrichtung 1 entlang der in Fig. 1 mit II-II bezeichneten Richtung. Die Schnittebene der teilweise geschnittenen Seitenansicht ist eine vertikale Ebene, die die Transportebene entlang einer Linie schneidet, an der ein Nutzbereich des Behandlungsgutes transportiert wird.

Die Vorrichtung 1 umfasst eine Walze 2 und eine weitere Walze 3, die an gegenüberliegenden Seiten einer Transportebene für das Behandlungsgut 10 so angeordnet sind, dass das Behandlungsgut 10 zwischen der Walze 2 und der weiteren Walze 3 transportiert wird. Die Vorrichtung 1 kann beispielsweise als Paar von Abquetschwalzen 213 oder 215 bei der Behandlungsstation 200 von Fig. 18 eingesetzt werden.

Die Walze 2 weist eine als Rückhaltefläche ausgebildete Walzenoberfläche 4 zum Zurückhalten von Behandlungsflüssigkeit auf, die als abgesetzter Abschnitt der Mantelfläche der Walze 2 vorgesehen ist. Die Walze 2 ist relativ zu einem Transportweg des Behandlungsgutes 10 so positioniert, dass ein Spalt 8 zwischen der Rückhaltefläche 4 und dem Behandlungsgut 10 freibleibt, wenn das Behandlungsgut 10 an der Walze 2 vorbei transportiert wird. Der die Rückhaltefläche 4 bildende Abschnitt der Mantelfläche der Walze 2 kann im Wesentlichen zylinderförmig ausgebildet sein.

Die weitere Walze 3 weist eine weitere als Rückhaltefläche ausgebildete Walzenoberfläche 14 zum Zurückhalten von Behandlungsflüssigkeit auf, die als abgesetzter Abschnitt der Mantelfläche der Walze 3 vorgesehen ist. Die weitere Walze 3 ist relativ zu dem Transportweg des Behandlungsgutes 10 so positioniert, dass ein Spalt 18 zwischen der weiteren Rückhaltefläche 14 und dem Behandlungsgut 10 freibleibt, wenn das Behandlungsgut 10 an der Walze 3 vorbei transportiert wird. Der die weitere Rückhaltefläche 14 bildende Abschnitt der Mantelfläche der Walze 3 kann im Wesentlichen zylinderförmig ausgebildet sein.

Aufgrund der Spalte 8, 18, die durch die Anordnung und Ausgestaltung der Walze 2 und der weiteren Walze 3 ausgebildet werden, kommt ein Nutzbereich 11 des Behandlungsgutes 10, der sich über einen Großteil der Breitenrichtung des Behandlungsgutes 10 erstreckt, nicht mit festen Elementen der Vorrichtung 1 in Berührung. Die Gefahr einer Beschädigung der Oberflächen des Behandlungsgutes 10 im Nutzbereich 11 kann auf diese Weise verringert werden.

Aufgrund der Zylinderform der Rückhaltefläche 4 und der weiteren Rückhaltefläche 14 weisen die Spalte 8, 18 eine in Transportrichtung 20 des Behandlungsgutes 10 veränderliche Spalthöhe bzw. lichte Höhe auf. Eine minimale Spalthöhe 9, 19 der Spalte 8, 18 wird durch diejenigen Punkte der Rückhalteflächen 4, 14 bestimmt, die den geringsten Abstand zu der der jeweiligen Walze 2 bzw. 3 gegenüberliegenden Oberfläche des Behandlungsgutes 10 aufweisen.

Auch wenn die Spalte 8, 18 einen Durchtritt von Behandlungsflüssigkeit erlauben, kann mit der Vorrichtung 1 Behandlungsflüssigkeit von dem Behandlungsgut 10 entfernt werden. Insbesondere kann die Vorrichtung 1 durch die Verjüngung der Spalte 8, 18 bis auf die minimale Spalthöhe 9, 19 einen Druckverlust hervorrufen, der zu unterschiedlichen Flüssigkeitsniveaus der Behandlungsflüssigkeit an den beiden in Transportrichtung 20 gegenüberliegenden Seiten der Walze 2 führen kann.

Fig. 2 zeigt schematisch eine Behandlungsflüssigkeit 21, die an einer Seite der Walze 2 bis zu einem Niveau 22 angestaut ist, und einen nach dem Vorbeiführen des Behandlungsgutes 10 an der Vorrichtung 1 verbleibende Schicht von Behandlungsflüssigkeit 23, die ein niedrigeres Niveau 24 aufweist. Die Vorrichtung 1 kann insbesondere so eingerichtet sein, dass die Behandlungsflüssigkeit 21 an einer Seite der Walzen 2, 3 (in Fig. 2 auf der linken Seite der Walzen 2, 3) von der Rückhaltefläche 4 und der weiteren Rückhaltefläche 14 bis zu dem Niveau 22 angestaut wird, das unmittelbar an der Rückhaltefläche 4 höher als die minimale Spalthöhe 9 des Spaltes 8 und als die minimale Spalthöhe 19 des Spaltes 18, jeweils gemessen von der Unterkante des entsprechenden Spaltes 8, 18 an der Position mit minimaler Spalthöhe, ist.

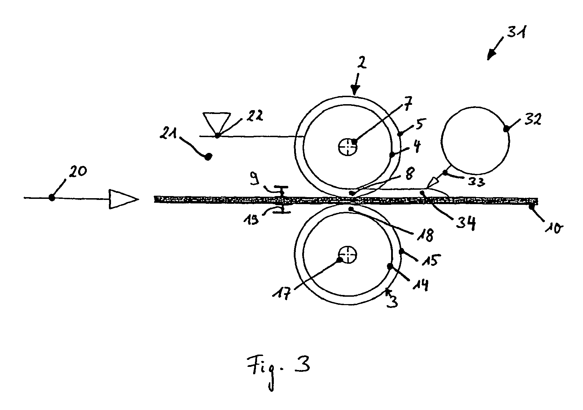

Wie unter Bezugnahme auf Fig. 3-6, 9 und 10 noch näher erläutert werden wird, kann die nach dem Vorbeiführen des Behandlungsgutes 10 an den Rückhalteflächen 4, 14 noch an dem Behandlungsgut verbleibende Behandlungsflüssigkeit 23 auf geeignete Weise entfernt werden, beispielsweise durch Anströmen des Behandlungsgutes mit einem Fluidstrom.

Die Walzen 2, 3 der Vorrichtung 1 können nicht nur zum Entfernen von Flüssigkeit von dem Behandlungsgut 10, sondern auch zum Transportieren des Behandlungsgutes 10 eingerichtet sein. Dazu kann die Walze 2 an ihren beiden axialen Enden erhöhte Randabschnitte 5, 6 aufweisen, die in Anlage mit einem Randbereich 12 des Behandlungsgutes 10 gebracht werden, wenn das Behandlungsgut an den Walzen 2, 3 vorbeigeführt wird. Die erhöhten Randabschnitte 5, 6 können drehend angetrieben werden, um das Behandlungsgut 10 zu transportieren. Zum drehenden Antrieb der Randabschnitte 5, 6 ist eine Welle 7 vorgesehen, die bei Verwendung der Vorrichtung 1 in einer Behandlungsanlage für das Behandlungsgut 10 drehbar gelagert ist. Durch Drehung der Randabschnitte 5, 6 in einer Drehrichtung 25 kann das Behandlungsgut 10 weitertransportiert werden. Entsprechend kann die Walze 3 an ihren beiden axialen Enden erhöhte Randabschnitte 15, 16 aufweisen, die in Anlage mit einem Randbereich 12 des Behandlungsgutes 10 gebracht werden, wenn das Behandlungsgut an den Walzen 2, 3 vorbeigeführt wird. Die erhöhten Randabschnitte 15, 16 können drehend angetrieben werden, um das Behandlungsgut 10 zu transportieren. Zum drehenden Antrieb der Randabschnitte 15, 16 ist eine Welle 17 vorgesehen, die bei Verwendung der Vorrichtung 1 in einer Behandlungsanlage für das Behandlungsgut 10 drehbar gelagert ist. Durch Drehung der Randabschnitte 15, 16 in einer Drehrichtung 26 kann das Behandlungsgut 10 weitertransportiert werden.

Die Randabschnitte 5, 6 und/oder die Randabschnitte 15, 16 können in einem Reibschluss und/oder in einem Formschluss mit dem Behandlungsgut 10 stehen, um dieses zu transportieren. Beispielsweise können an den Randabschnitten 5, 6 und/oder an den Randabschnitten 15, 16 Vorsprünge ausgebildet sein, die in korrespondierende Ausnehmungen des Behandlungsgutes 10 eingreifen, um das Behandlungsgut 10 zu transportieren.

Bei der Walze 2 wirken die erhöhten Randabschnitte 5, 6 als Transportabschnitte, die zum Transportieren des Behandlungsgutes 10 mit dem Behandlungsgut 10 gekoppelt werden können. Die Rückhaltefläche 4 ist relativ zu den Randabschnitten 5, 6 abgesetzt. Die Erhöhung bzw. der im Vergleich zum Radius der Rückhaltefläche 4 größere Radius der Randabschnitte 5, 6 bestimmt die minimale Spalthöhe 9. Entsprechend wirken bei der Walze 3 die erhöhten Randabschnitte 15, 16 als Transportabschnitte, die zum Transportieren des Behandlungsgutes 10 mit dem Behandlungsgut 10 gekoppelt werden können. Die Rückhaltefläche 14 ist relativ zu den Randabschnitten 15, 16 abgesetzt. Die Erhöhung bzw. der im Vergleich zum Radius der Rückhaltefläche 14 größere Radius der Randabschnitte 15, 16 bestimmt die minimale Spalthöhe 19.

Die Radien der Randabschnitte und der Rückhaltefläche können für das gewünschte Anwendungsgebiet geeignet gewählt werden. Beispielsweise kann der Radius des die Rückhaltefläche bildenden Abschnitts der Walze 2, 3 um weniger als 1 mm, insbesondere um weniger als 0,7 mm, insbesondere um weniger als 0,5 mm kleiner als der Radius der Randabschnitte der Walze 2, 3 sein, die als Transportabschnitte dienen. Der Radius des die Rückhaltefläche bildenden Abschnitts der Walze 2, 3 kann um mindestens 0,05 mm, insbesondere um mindestens 0,07 mm, insbesondere um mindestens 0,09 mm kleiner als der Radius der Randabschnitte der Walze 2, 3 sein, die als Transportabschnitte dienen.

Zusätzlich kann die Welle 7 der Walze 2 und/oder die Welle 17 der weiteren Walze 3 mit einem höhenverstellbaren Lager derart gelagert sein, dass ein Abstand der Welle 7 von der oberen Oberfläche des Behandlungsgutes 10 und/oder ein Abstand der Welle 17 von der unteren Oberfläche des Behandlungsgutes 10 eingestellt werden kann.

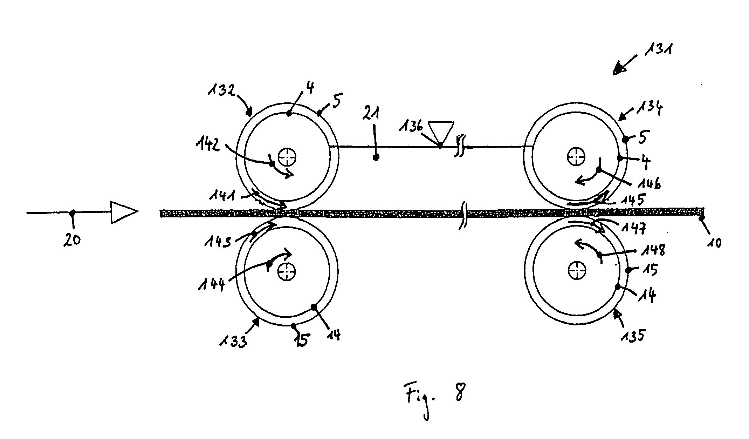

Die Walze 2 und die weitere Walze 3 können so eingerichtet sein, dass sich bei Drehung der als Transportabschnitte dienenden Randabschnitte 5, 6 bzw. 15, 16 auch die Rückhalteflächen 4 bzw. 14 der jeweiligen Walze gleichsinnig mit den Transportabschnitte der jeweiligen Walze drehen. Dazu können die Walze 2 bzw. die Walze 3 beispielsweise so ausgestaltet sein, dass sowohl die Transportabschnitte als auch die Rückhaltefläche an ihrer Oberfläche drehfest zueinander ausgebildet sind. Da der Teil 4 bzw. 14 der Walzenoberfläche, der von dem Nutzbereich 11 des Behandlungsgutes 10 beabstandet ist und den Spalt 8 bzw. den Spalt 18 begrenzt, gegenüber den Transportabschnitten 5, 6 oder 15, 16 abgesetzt ist, weist die Walzenoberfläche der Walze 2, 3 eine Umfangsgeschwindigkeit auf, die von der Transportgeschwindigkeit des Behandlungsgutes 10 verschieden ist. Alternativ können jedoch die Transportabschnitte relativ zu der Rückhaltefläche drehbar vorgesehen sein, wie unter Bezugnahme auf Fig. 8 noch näher erläutert werden wird.

Bei einem Ausführungsbeispiel können die Transportabschnitte relativ zu der Rückhaltefläche drehbar vorgesehen sein. Eine Winkelgeschwindigkeit der Rückhaltefläche kann abhängig von einer Winkelgeschwindigkeit der Transportabschnitte, einem Radius der Transportabschnitte und einem Radius des die Rückhaltefläche bildenden Abschnitts der Walze ausgewählt werden.

Mehrere Abwandlungen der Vorrichtung 1 können bei weiteren Ausführungsbeispielen realisiert werden.

Während beispielsweise die Walzen 2, 3 der Vorrichtung 1 an ihren axialen Enden Erhöhungen 5, 6, 15, 16 aufweisen, können entweder an der Walze 2 oder an der weiteren Walze 3 auch mehr als zwei erhöhte Abschnitte vorgesehen sein. Die weiteren erhöhten Abschnitte können dabei insbesondere so an der Walze 2 oder an der weiteren Walze 3 angeordnet sein, dass sie das Behandlungsgut 10 an Oberflächenbereichen berühren, an denen ein derartiger mechanischer Kontakt unkritisch ist. Beispielsweise können in Längsrichtung des Behandlungsgutes 10 verlaufende Oberflächenbereiche des Behandlungsgutes mit weiteren Erhöhungen der Walze 2 oder der weiteren Walze 3 abgestützt werden, falls an einer der Seiten des Behandlungsgutes ein derartiger Kontakt nicht kritisch sein sollte. Die zusätzliche Stützwirkung, die durch die weiteren Erhöhungen bewirkt wird, kann die Gefahr einer unerwünschten Berührung des Behandlungsgutes 10 in seinem Nutzbereich verringern.

Während bei der Vorrichtung 1 Rückhalteflächen 4, 14, die einen Spalt mit einer Oberfläche des Behandlungsgutes ausbilden, sowohl oberhalb als auch unterhalb der Transportebene vorgesehen sind, kann bei einer Vorrichtung nach einem weiteren Ausführungsbeispiel auch nur an einer Seite eine Rückhaltefläche vorgesehen sein, die mit einer Oberfläche des Behandlungsgutes einen Spalt ausbildet. Beispielsweise kann eine derartige spaltbildende Rückhaltefläche nur an der Oberseite oder nur an der Unterseite der Transportebene angeordnet sein. An der gegenüberliegenden Seite kann beispielsweise eine Walze vorgesehen sein, die einen im Wesentlichen konstanten Durchmesser aufweist. Die an der anderen Seite vorgesehene spaltbildende Rückhaltefläche kann zu einer Reduzierung der auf die Oberflächen des Behandlungsgutes ausgeübten Kräfte führen, um die Gefahr einer Beschädigung der Oberflächen zu verringern.

Bei einem weiteren Ausführungsbeispiel kann auch eine Mantelfläche einer Walze mit einem Durchmesser, der konstant ist, d.h. der nicht entlang der Axialrichtung der Walze variiert, als Rückhaltefläche dienen, die einen Spalt zwischen der Rückhaltefläche und der Oberfläche des Behandlungsgutes definiert. Die Ausgestaltung des Spaltes, insbesondere die minimale Spalthöhe, kann einstellbar gemacht werden, indem die Walze mit einem Lager gelagert ist, das relativ zu der Transportebene höhenverstellbar ist. Es können auch zwei derartige Walzen vorgesehen sein, um an der Ober- und an der Unterseite des Behandlungsgutes Flüssigkeit zu entfernen, wobei ein Spalt zwischen der entsprechenden Walze und dem Behandlungsgut ausgebildet bleibt.

Fig. 3 ist eine schematische Seitenansicht einer Vorrichtung 31 zum Entfernen von Behandlungsflüssigkeit nach einem weiteren Ausführungsbeispiel. Die Vorrichtung 31 kann beispielsweise im Auslaufbereich der Behandlungsstation 200 von Fig. 18 anstelle der Paare von Abquetschwalzen 214, 215, 216 verwendet werden. Elemente oder Einrichtungen der Vorrichtung 31, die in ihrer Funktion und/oder Ausgestaltung Elementen oder Einrichtungen der Vorrichtung 1 entsprechen, sind mit denselben Bezugszeichen versehen und werde nicht erneut eingehend erläutert.

Die Vorrichtung 31 umfasst eine als Rückhaltefläche 4 ausgebildete Walzenoberfläche zum Zurückhalten von Flüssigkeit. Die Vorrichtung 31 ist so eingerichtet, dass die Rückhaltefläche 4 mit der ihr gegenüberliegenden Oberfläche eines Behandlungsgutes 10

(in Fig. 3 mit der oberen Oberfläche des Behandlungsgutes 10) einen Spalt 8 ausbildet. Die Rückhaltefläche 4 ist an der drehbar gelagerten Walze 2 vorgesehen sein. Die Walze 2 kann wie unter Bezugnahme auf Fig. 1 und 2 beschrieben ausgestaltet sein. Insbesondere kann, wie unter Bezugnahme auf Fig. 1 und 2 beschrieben wurde, die Umfangsgeschwindigkeit der Walzenoberfläche an dem Spalt 8 von der Transportgeschwindigkeit des Behandlungsgutes 10 verschieden sein. Die Rückhaltefläche 4 entfernt Behandlungsflüssigkeit von dem an der Rückhaltefläche 4 vorbeitransportierten Behandlungsgut 10. Da der Spalt 8 bei einem Ausführungsbeispiel den Durchtritt von Behandlungsflüssigkeit erlaubt, kann auch noch Behandlungsflüssigkeit 34 an dem Behandlungsgut 10 vorhanden sein, nachdem dieses die Walze 2 mit der Rückhaltefläche 4 passiert hat.

Die Vorrichtung 31 umfasst weiterhin eine Anströmeinrichtung 32 mit einer Düsenanordnung. Die Anströmeinrichtung 32 ist in Transportrichtung beabstandet von der Walze 2 und der an der Walze 2 vorgesehenen Rückhaltefläche 4 angeordnet. Die Anströmeinrichtung 32 ist in Transportrichtung stromabwärts, d.h. in Transportrichtung nach, der Walze 2 mit der Rückhaltefläche 4 angeordnet. Die Anströmeinrichtung 32 ist eingerichtet, um einen Teil der Behandlungsflüssigkeit 34, die nach Passieren des Spaltes 8 an dem Behandlungsgut 10 verblieben ist, von dem Behandlungsgut 10 zu entfernen. Die Anströmeinrichtung 32 kann insbesondere eingerichtet sein, um einen Großteil der Behandlungsflüssigkeit 34, die nach Passieren des Spaltes 8 an dem Behandlungsgut 10 verblieben ist, von dem Behandlungsgut 10 zu entfernen.

Die Anströmeinrichtung 32 kann einen Fluidstrom 33, insbesondere einen Gasstrom, beispielsweise einen Luftstrom, ausgeben, um die Behandlungsflüssigkeit 34 von dem Behandlungsgut 10 abzublasen oder anderweitig mit dem Fluidstrom 33 zu entfernen. Der Fluidstrom 33 kann zumindest eine Strömungskomponente in Richtung der spalterzeugenden Rückhaltefläche 4 der Vorrichtung 31 aufweisen (in Fig. 3 eine nach links gerichtete Komponente). An der Rückhaltefläche 4 kann die Behandlungsflüssigkeit seitlich von dem Behandlungsgut strömen.

Die Anströmeinrichtung kann auch so eingerichtet sein, dass der Fluidstrom 33 eine Strömungskomponente aufweist, die parallel zu der Transportebene und quer zu der Transportrichtung 20 gerichtet ist, d.h. parallel zu der Axialrichtung der Walze 2 weist, an der die Rückhaltefläche 4 ausgebildet ist. Auf diese Weise kann die Behandlungsflüssigkeit 34 seitlich von dem Behandlungsgut 10 entfernt werden.

Die Anströmeinrichtung 32 kann sich über die gesamte Breite des Behandlungsgutes 10, d.h. über die Ausdehnung des Behandlungsgutes 10 quer zu der Transportrichtung, über das Behandlungsgut 10 erstrecken. Zum Ausgeben des Fluidstroms 33 kann die Anströmeinrichtung 32 eine oder mehrere Düsenöffnungen aufweisen. Die Düsenöffnungen können beispielsweise als ein durchgehender Schlitz, mehrere Schlitze oder eine Vielzahl von Bohrungen ausgebildet sein, der bzw. die in Breitenrichtung des Behandlungsgutes 10 an der Anströmeinrichtung 32 ausgebildet ist bzw. sind. Die Anströmeinrichtung 32 kann so ausgestaltet sein, dass der Abstand der Düsenöffnungen zu der Oberfläche des Behandlungsgutes 10 über die gesamte Breite des Behandlungsgutes im Wesentlichen gleich groß ist.

Die Anströmeinrichtung 32 kann einen geraden Kanalkörper umfassen, welcher parallel zur Transportebene und quer zu der Transportrichtung 20 gerichtet ist. Der Kanalkörper kann alternativ auch parallel zur Transportebene und schräg zu der Transportrichtung 20 ausgerichtet sein.

Bei einem Ausführungsbeispiel kann die Anströmeinrichtung 32 so ausgeformt sein, dass ein in Breitenrichtung des Behandlungsgutes mittlerer Abschnitt der Anströmeinrichtung 32 näher an der spaltbildenden Rückhaltefläche 4 angeordnet ist als ein Randabschnitt der Anströmeinrichtung 32. Beispielsweise kann die Anströmeinrichtung 32 eine Form aufweisen, die in einer Draufsicht aus einer Richtung senkrecht zu der Transportebene (d.h. in Fig. 3 bei Blick senkrecht von oben auf die Transportebene) eine zu dem von der Rückhaltefläche 4 ausgebildeten Spalt 8 hin konvexe Form aufweist. Beispielsweise kann die Anströmeinrichtung 32 in Draufsicht eine V-Form aufweisen, deren Spitze zur Rückhaltefläche 4 hin zeigt. Eine so ausgebildete Anströmeinrichtung ist eingerichtet, um den Fluidstrom mit einer Geschwindigkeitskomponente in Richtung eines Randes des Behandlungsgutes auszugeben, um in effektiver Weise die Behandlungsflüssigkeit zu dem Rand des Behandlungsgutes hin zu befördern und so zu entfernen.

Die Anströmeinrichtung 32 kann eingerichtet sein, um einen Gasstrom, insbesondere einen Luftstrom, auszugeben und das Behandlungsgut damit anzuströmen. Die Anströmeinrichtung 32 kann so eingerichtet sein, dass eine Ausströmgeschwindigkeit des Gasstromes 33 mindestens 2 m/sec, insbesondere mindestens 10 m/sec, insbesondere mindestens 30 m/sec beträgt.

Die Anströmeinrichtung 32 kann auch eingerichtet sein, um einen Flüssigkeitsstrom auszugeben und das Behandlungsgut damit anzuströmen. Die Anströmeinrichtung 32 kann so eingerichtet sein, dass eine Ausströmgeschwindigkeit des Flüssigkeitsstromes 33 mindestens 0,1 m/sec, insbesondere mindestens 1 m/sec, insbesondere mindestens 3 m/sec beträgt.

Die Anströmeinrichtung 32 kann so eingerichtet sein, dass eine Ausströmrichtung des Fluidstromes 33 parallel oder schräg zu der Oberfläche des Behandlungsgutes sein kann. Insbesondere kann die Anströmeinrichtung 32 so ausgebildet sein, dass der Fluidstrom aus den Düsenöffnungen der Anströmeinrichtung 32 in Richtung des Spaltes 8 und/oder quer zu der Transportrichtung in Richtung eines Randes des Behandlungsgutes 10 ausströmt. Alternativ kann die Ausströmrichtung auch senkrecht auf die Oberfläche des Behandlungsgutes 10 gerichtet sein.

Die Anströmeinrichtung 32 kann so ausgebildet sein, dass der Fluidstrom 33 nicht durch den Spalt 8 hindurchtritt, d.h. nicht in die auf der entgegengesetzten Seite der spaltbildenden Rückhaltefläche 4 angestaute Behandlungsflüssigkeit eintritt. Auf diese Weise kann vermieden oder unterdrückt werden, dass der Fluidstrom 33 eine Blasenbildung in der Behandlungsflüssigkeit 21 hervorruft. Um den Durchtritt des Fluidstroms 33 durch den Spalt 8 zu vermeiden, kann beispielsweise einer oder eine oder mehrere von einem Volumenstrom, der Ausströmgeschwindigkeit und/oder der Ausströmrichtung des Fluidstroms 33 aus der Anströmeinrichtung 32 entsprechend eingestellt werden.

Die Vorrichtung 31 kann so ausgebildet sein, dass ein Abstand oder die verschiedenen Abstände zwischen dem Spalt 8 und der Düsenöffnung bzw. den Düsenöffnungen der Anströmeinrichtung 32 höchstens 100 mm und mindestens 10 mm beträgt bzw. betragen.

Wie in Fig. 3 dargestellt kann die Vorrichtung 31 weiterhin eine unterhalb der Transportebene angeordnete weitere als Rückhaltefläche 14 ausgebildete Walzenoberfläche aufweisen, die an einer weiteren Walze 3 ausgebildet ist.

Mehrere Abwandlungen der Vorrichtung 31 können bei weiteren Ausführungsbeispielen realisiert werden. Während beispielsweise unter Bezugnahme auf Fig. 3 eine Vorrichtung 31 zum Entfernen von Behandlungsflüssigkeit erläutert wurde, bei der die Anströmeinrichtung 32 in Transportrichtung des Behandlungsgutes 10 der Walze 2 mit der spaltbildenden Rückhaltefläche 4 nachgeordnet ist, kann eine Vorrichtung zum Abhalten von Behandlungsflüssigkeit auch so ausgestaltet sein, dass die Anströmeinrichtung in Transportrichtung des Behandlungsgutes vor bzw. stromaufwärts der spaltbildenden Rückhaltefläche angeordnet ist. Eine so ausgebildete Vorrichtung kann insbesondere in einem Einlaufbereich einer Behandlungsstation verwendet werden.

Bei einer Vorrichtung zum Entfernen oder Abhalten von Behandlungsflüssigkeit nach einem weiteren Ausführungsbeispiel kann die Anströmeinrichtung 32 alternativ oder zusätzlich unterhalb der Transportebene vorgesehen sein, um Flüssigkeit von einer Unterseite des Behandlungsgutes 10 abzublasen oder anderweitig mit dem von der Anströmeinrichtung abgegebenen Fluidstrom 33 von dem Behandlungsgut 10 zu entfernen.

Falls die Anströmeinrichtung unterhalb der Transportebene vorgesehen ist, kann sie so ausgestaltet sein, dass der von der Anströmeinrichtung erzeugte Fluidstrom eine Geschwindigkeitskomponente parallel zu der Transportrichtung aufweist, die weg von der spalterzeugenden Rückhaltefläche gerichtet ist. Beispielsweise kann bei einer in einem Auslaufbereich einer Behandlungsstation vorgesehenen Anströmeinrichtung der von der Anströmeinrichtung erzeugte Fluidstrom eine in Transportrichtung gerichtete Geschwindigkeitskomponente aufweisen.

Falls eine Anströmeinrichtung zum Entfernen von Behandlungsflüssigkeit oberhalb der Transportebene vorgesehen ist, kann an der entsprechenden Position unterhalb der Transportebene ein Trannsportelement vorgesehen sein. Ähnlich kann, falls eine Anströmeinrichtung zum Entfernen von Behandlungsflüssigkeit unterhalb der Transportebene vorgesehen ist, an der entsprechenden Position oberhalb der Transportebene ein Trannsportelement vorgesehen sein. Das Transportelement und die Anströmeinrichtung können an derselben Position in Transportrichtung an entgegengesetzten Seiten der Transportebene angeordnet sein.

Das Transportelement kann beispielsweise eingerichtet sein, um das Behandlungsgut abzustützen und/oder zu transportieren. Das Transportelement kann als Walze ausgebildet sein. Die Walze kann eine abgesetzte Rückhaltefläche aufweisen, kann aber auch einen in Axialrichtung im Wesentlichen konstanten Durchmesser aufweisen. Das Transportelement kann auch als Rädchenachse ausgebildet sein, an der mehrere Rädchen vorgesehen sind. Die Rädchen können ausgestaltet sein, um das Behandlungsgut zum Transportieren des Behandlungsgutes zu berühren.

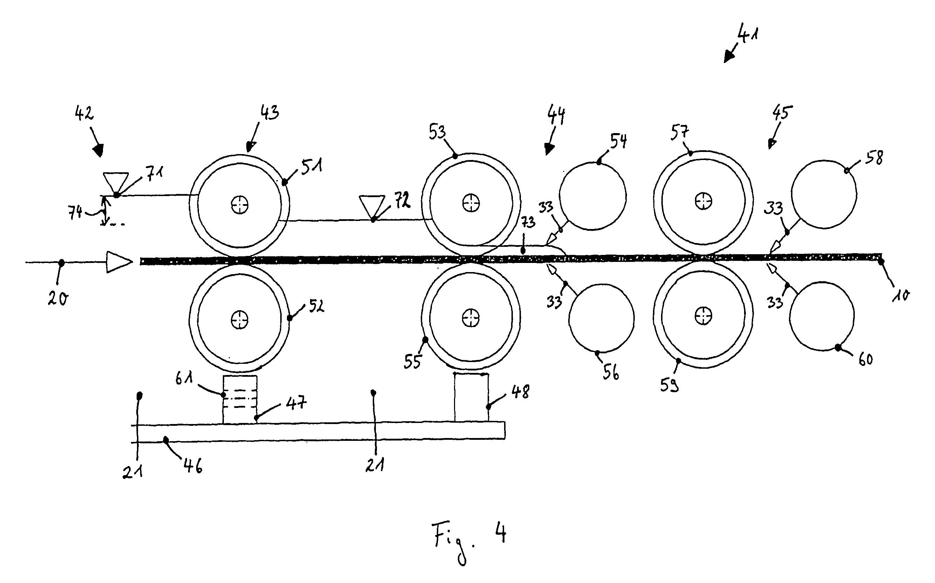

Fig. 4 ist eine schematische Seitenansicht eines Auslaufbereichs 41 einer Behandlungsstation. Ein derartiger Auslaufbereich 41 kann bei der Behandlungsstation 200 von Fig. 18 an einem Ende des Innenbehälters 201 vorgesehen werden, an dem das Behandlungsgut die Behandlungsstation verlässt. In dem Auslaufbereich wird ein Behandlungsgut 10 aus einem Behandlungsbereich 42, in dem eine Behandlungsflüssigkeit 21 das Behandlungsgut überdeckt, in einer Transportrichtung 20 weitertransportiert.

Der Auslaufbereich 41 umfasst mehrere Vorrichtungen 43, 44 und 45 zum Entfernen von Behandlungsflüssigkeit von dem Behandlungsgut 10. Die Vorrichtungen 43, 44 und 45 zum Entfernen der Behandlungsflüssigkeit sind voneinander in Transportrichtung 20 beabstandet entlang einem Transportweg des Behandlungsgutes 10 angeordnet. Jede der Vorrichtungen 43, 44 und 45 kann eine Rückhaltefläche aufweisen, die relativ zu der Transportebene so angeordnet ist, dass ein Spalt zwischen der Rückhaltefläche und der ihr gegenüberliegenden Oberfläche des Behandlungsgutes 10 ausgebildet wird.

Die Vorrichtungen 43, 44 und 45 können als Vorrichtungen zum Entfernen von Behandlungsflüssigkeit nach einem Ausführungsbeispiel ausgebildet sein. Bei einem Ausführungsbeispiel kann die Vorrichtung 43 ein Paar von Walzen 51, 52 umfassen, die so angeordnet sind, dass das Behandlungsgut 10 dazwischen durchgeführt werden kann. An wenigstens einer der Walzen 51, 52 der Vorrichtung 43 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 51, 52 vorbeigeführt wird. Insbesondere kann wenigstens eine der Walzen 51, 52 erhöhte Randbereiche zum Transportieren des Behandlungsgutes 10 und eine dazwischen vorgesehene abgesetzte Rückhaltfläche aufweisen. Die Vorrichtung 43 kann beispielsweise wie die unter Bezugnahme auf Fig. 1 und 2 erläuterte Vorrichtung 1 ausgebildet sein. Wenigstens die Walze 51, 52, an der die spaltbildende Rückhaltefläche ausgebildet ist, wird so angetrieben, dass sich die Umfangsgeschwindigkeit der Walzenoberfläche an dem Rand des Spaltes, d.h. entlang der Linie, an der die Walzenoberfläche durch die minimale Spalthöhe von dem Behandlungsgut 10 getrennt ist, in Richtung und/oder Betrag von der Transportgeschwindigkeit des Behandlungsgutes 10 unterscheidet.

Die Vorrichtung 44 kann eine oberhalb des Transportebene angeordnete Walze 53 und Anströmeinrichtung 54 und eine unterhalb der Transportebene angeordnete Walze 55 und Anströmeinrichtung 56 aufweisen. An wenigstens einer der Walzen 53, 55 der Vorrichtung 44 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 53, 55 vorbeigeführt wird. Insbesondere kann wenigstens eine der Walzen 53, 55 erhöhte Randbereiche zum Transportieren des Behandlungsgutes 10 und eine dazwischen vorgesehene abgesetzte Rückhaltfläche aufweisen, wie unter Bezugnahme auf Fig. 1 und 2 erläutert. Die Anströmeinrichtungen 54 und 56 strömen das Behandlungsgut 10 mit einem Fluidstrom 33, beispielsweise einem Luftstrom an, um an dem Behandlungsgut verbliebene Behandlungsflüssigkeit zu entfernen. Dazu können die von den Anströmeinrichtungen 54 und 56 abgegebenen Fluidströme 33 so gerichtet sein, dass sie die Behandlungsflüssigkeit in Richtung eines Randes des Behandlungsgutes bewegen und so entfernen.

Die Vorrichtung 45 kann eine oberhalb des Transportebene angeordnete Walze 57 und Anströmeinrichtung 58 und eine unterhalb der Transportebene angeordnete Walze 59 und Anströmeinrichtung 60 aufweisen. An wenigstens einer der Walzen 57, 59 der Vorrichtung 45 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 57, 59 vorbeigeführt wird. Insbesondere kann wenigstens eine der Walzen 57, 59 erhöhte Randbereiche zum Transportieren des Behandlungsgutes 10 und eine dazwischen vorgesehene abgesetzte Rückhaltfläche aufweisen, wie unter Bezugnahme auf Fig. 1 und 2 erläutert. Die Anströmeinrichtungen 58 und 60 strömen das Behandlungsgut 10 mit einem Fluidstrom 33, beispielsweise einem Luftstrom an, um an dem Behandlungsgut verbliebene Behandlungsflüssigkeit zu entfernen. Dazu können die von den Anströmeinrichtungen 58 und 60 abgegebenen Fluidströme 33 so gerichtet sein, dass sie die Behandlungsflüssigkeit in Richtung eines Randes des Behandlungsgutes bewegen und so entfernen.

Von den Walzen 53, 55, 57, 59 können wenigstens diejenigen, die einen Spalt zwischen der entsprechenden Walze und dem Behandlungsgut ausbilden, so gedreht werden, dass die Umfangsgeschwindigkeit der Walze an dem Spalt in Betrag und/oder Richtung von der Transportgeschwindigkeit des Behandlungsgutes 10 verschieden ist.

Die spaltbildenden Rückhalteflächen der Vorrichtungen 43, 44 und 45, die das Behandlungsgut 10 nacheinander passiert, können eine unterschiedliche Ausgestaltung aufweisen. Beispielsweise können die Spalte an den Vorrichtungen zunehmend enger werden. Beispielsweise kann die Vorrichtung 43 so ausgestaltet sein, dass ein Spalt mit einer ersten minimalen Spalthöhe zwischen der Rückhaltefläche der Vorrichtung 43 und der gegenüberliegenden Oberfläche des Behandlungsgutes 10 ausgebildet wird, während die der Vorrichtung 43 in Transportrichtung nachgeordnete Vorrichtung 44 so ausgestaltet sein kann, dass ein Spalt mit einer zweiten minimalen Spalthöhe zwischen der Rückhaltefläche der Vorrichtung 44 und der gegenüberliegenden Oberfläche des Behandlungsgutes 10 ausgebildet wird. Dabei kann die zweite minimale Spalthöhe an der Vorrichtung 44 kleiner sein als die erste minimale Spalthöhe an der Vorrichtung 43, d.h. die Spalte können im Auslaufbereich der Behandlungsstation von einer Vorrichtung zu einer dieser in Transportrichtung nachgeordneten anderen Vorrichtung zum Entfernen von Behandlungsflüssigkeit eine kleinere Höhe aufweisen.

Die Vorrichtung 43, die den Behandlungsbereich 42 begrenzt, ist so eingerichtet, dass ein Niveauunterschied 74 der Behandlungsflüssigkeit zwischen den in Transportrichtung entgegengesetzten Seiten der Walze 51 eingestellt wird. In dem Behandlungsbereich 42 ist die Behandlungsflüssigkeit 21 bis zu einem Niveau 71 angestaut, während in dem benachbarten Bereich an der anderen Seite der Walze 51 die Behandlungsflüssigkeit bis zu einem Niveau 72 angestaut ist.

Die Vorrichtung 44, die in Transportrichtung der Vorrichtung 43 nachgeordnet ist, ist so eingerichtet, dass Behandlungsflüssigkeit von dem Behandlungsgut 10 entfernt wird, wenn das Behandlungsgut 10 die Walzen 53, 55 passiert. Behandlungsflüssigkeit 73, die nach dem Vorbeiführen des Behandlungsgutes 10 an den Walzen 53, 55 noch an dem Behandlungsgut 10 vorhanden ist, wird durch die Anströmeinrichtungen 54, 56 zumindest teilweise entfernt. Durch die Vorrichtung 45, die in Transportrichtung der Vorrichtung 44 nachgeordnet ist, kann ein weiterer Teil der Behandlungsflüssigkeit von dem Behandlungsgut entfernt werden, der nach dem Durchlaufen der Vorrichtung 44 noch an dem Behandlungsgut 10 vorhanden sein kann.

Durch die Verwendung mehrerer Vorrichtungen zum Entfernen von Behandlungsflüssigkeit kann Behandlungsflüssigkeit zuverlässig von dem Behandlungsgut 10 entfernt werden, selbst wenn Spalte zwischen den Rückhalteflächen und dem Behandlungsgut 10 freibleiben.

Zwischen einem Boden 46 eines Innenbehälters der Behandlungsstation und der unterhalb der Transportebene angeordneten Walze 52 der Vorrichtung 43 ist ein Wehr 47 vorgesehen. Mit dem Wehr 47 kann ein Niveauunterschied 74 zwischen den Flüssigkeitsniveaus 71, 72 an den beiden Seiten der Vorrichtung 43 eingestellt werden. Dazu sind in dem Wehr 47 Öffnungen 61, beispielsweise in der Form von Langlöchern, Bohrungen oder Schlitzen ausgebildet. Die Öffnungen 61 können verschließbar sein, um den Flüssigkeitsdurchtritt durch das Wehr 47 einzustellen und somit den Niveauunterschied 74 zwischen den Flüssigkeitsniveaus 71 und 72 einzustellen.

Das Niveau 72 in dem dem Behandlungsbereich 42 benachbarten Bereich wird bestimmt durch ein Gleichgewicht aus zu- und ablaufenden Strömen von Behandlungsflüssigkeit. Um diese und somit das Niveau 72 einstellen zu können, können in dem Boden 46 zwischen den Wehren 47, 48 eine oder mehrere Öffnungen, beispielsweise verschließbare Bohrungen, vorgesehen sein. Durch geeignete Wahl der in dem Wehr 47 geöffneten Öffnungen und der in dem Boden 46 geöffneten Öffnungen kann eine Grundeinstellung für ein gewünschtes Niveau 72 in dem dem Behandlungsbereich 42 benachbarten Bereich gewählt werden. Zusätzlich können an Elementen, die die Behandlungsstation seitlich begrenzen, beispielsweise an Lageraufnahmen, die für die Lagerung der Walzen 51, 52, 53 und 55 vorgesehen sind, Überlaufwehre vorgesehen werden. Zusätzlich zulaufende Flüssigkeitsmengen können über die Überlaufwehre abgeführt werden.

Um den aus dem Behandlungsbereich 42 ablaufenden Strom von Behandlungsflüssigkeit auszugleichen, kann mit einer (nicht dargestellten) Pumpe Behandlungsflüssigkeit in den Behandlungsbereich 42 gefördert werden.

Zwischen dem Boden 46 des Innenbehälters der Behandlungsstation und der unterhalb der Transportebene angeordneten Walze 55 der Vorrichtung 44 ist ein Wehr 48 vorgesehen. Das Wehr 48 muss keine verschließbaren Öffnungen zum Einstellen des Flüssigkeitsniveaus aufweisen. Das Wehr 48 hilft mit, um ein Abfließen der Behandlungsflüssigkeit aus dem Behandlungsbereich zu verringern.

Bei weiteren Ausführungsbeispielen können Abwandlungen des Auslaufbereichs 41 realisiert sein. Bei einem Ausführungsbeispiel kann beispielsweise die Vorrichtung 45 weggelassen sein. Entsprechend können in dem Auslaufbereich zwei Vorrichtungen zu Entfernen von Behandlungsflüssigkeit vorgesehen sein. Wenigstens die in Transportrichtung letzte dieser Vorrichtungen kann eine Anströmeinrichtung aufweisen. Die Anströmeinrichtung kann zumindest oberhalb der Transportebene vorgesehen sein.

Bei einem weiteren Ausführungsbeispiel können mehrere Vorrichtungen zum Entfernen von Flüssigkeit vorgesehen sein, die ein Wehr mit einer Öffnung oder mehreren Öffnungen zum Einstellen eines Niveauunterschieds aufweisen. Das Wehr kann jeweils eine Ausgestaltung aufweisen, wie sie unter Bezugnahme auf das Wehr 47 erläutert wurde. Bei einem Ausführungsbeispiel können beispielsweise im Ein- oder Auslaufbereich zwei Vorrichtungen mit jeweils mindestens einer Walze vorgesehen sein, die eine Rückhaltefläche zum Zurückhalten von Flüssigkeit aufweist, die einen Spalt mit dem daran vorbeigeführten Behandlungsgut ausbildet, wobei bei jeder der Vorrichtungen unterhalb der Transportebene ein Wehr mit einer Öffnung oder mehreren Öffnungen vorgesehen ist, wie dies für das Wehr 47 beschrieben wurde. In Transportrichtung beabstandet zu diesen beiden Vorrichtungen kann eine weitere Vorrichtung vorgesehen sein, die eine der Vorrichtung 44 entsprechende Ausgestaltung aufweist. Auf diese Weise können beispielsweise in einem Ein- oder Auslaufbereich mindestens zwei Bereiche mit gegenüber dem Behandlungsbereich abgesenktem Niveau der Behandlungsflüssigkeit ausgebildet werden.

Während bei den Vorrichtungen 43-45 zum Entfernen von Flüssigkeit sowohl oberhalb als auch unterhalb der Transportebene jeweils eine Walze vorgesehen ist, die einen Spalt mit dem daran vorbeigeführten Behandlungsgut ausbildet, kann bei einem weiteren Ausführungsbeispiel jede der Vorrichtungen zum Entfernen von Flüssigkeit so ausgebildet sein, dass nur an den oberhalb der Transportebene vorgesehenen Walze eine Rückhaltefläche vorgesehen ist, die einen Spalt zwischen der Rückhaltefläche und dem daran vorbeigeführten Behandlungsgut freilässt. Die unterhalb der Transportebene vorgesehenen Walzen können einen in Axialrichtung der Walzen konstanten Durchmesser aufweisen.

Bei einem Ausführungsbeispiel kann eine der Anströmeinrichtungen 54, 56 durch ein Transportelement ersetzt sein. Das Transportelement kann eingerichtet sein, um das Behandlungsgut abzustützen und/oder zu transportieren. Das Transportelement kann beispielsweise als Walze oder als Rädchenachse ausgebildet sein. Alternativ oder zusätzlich kann eine der Anströmeinrichtungen 58, 60 durch ein Transportelement ersetzt sein. Das Transportelement kann eingerichtet sein, um das Behandlungsgut abzustützen und/oder zu transportieren. Das Transportelement kann beispielsweise als Walze oder als Rädchenachse ausgebildet sein.

Bei einem Ausführungsbeispiel kann eine der unterhalb der Transportebene vorgesehenen Anströmeinrichtungen 56, 60 so ausgebildet sein, dass der von der Anströmeinrichtung 56, 60 erzeugte Fluidstrom 33 eine Geschwindigkeitskomponente aufweist, die im Auslaufbereich 41 in Transportrichtung zeigt.

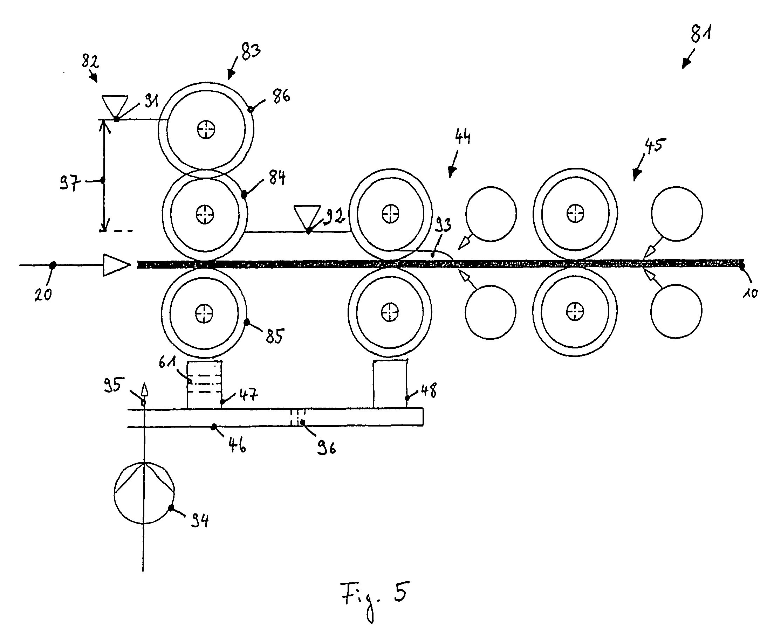

Fig. 5 ist eine schematische Seitenansicht eines Auslaufbereichs 81 einer Behandlungsstation. Ein derartiger Auslaufbereich 81 kann bei der Behandlungsstation 200 von Fig. 18 an einem Ende des Innenbehälters 201 vorgesehen werden, an dem das Behandlungsgut den Innenbehälter 201 verlässt. In dem Auslaufbereich wird ein Behandlungsgut 10 aus einem Behandlungsbereich 82, in dem eine Behandlungsflüssigkeit 21 das Behandlungsgut überdeckt, in einer Transportrichtung 20 weitertransportiert. Elemente oder Einrichtungen des Auslaufbereichs 81, die in ihrer Funktion und/oder Ausgestaltung Elementen oder Einrichtungen Auslaufbereichs 41 entsprechen, sind mit denselben Bezugszeichen versehen und werde nicht erneut eingehend erläutert.

In bestimmten Behandlungsstationen kann es wünschenswert sein, im Behandlungsbereich 82 ein relativ hohes Flüssigkeitsniveau 91 einzustellen. Das Flüssigkeitsniveau 91 in dem Behandlungsbereich 82 kann beispielsweise mindestens 15 mm über der Transportebene angeordnet sein.

Der Auslaufbereich 81 ist mit mehreren Vorrichtungen 83, 44 und 45 zum Entfernen oder Abhalten von Behandlungsflüssigkeit versehen. Die Vorrichtung 83 umfasst Walzen 84, 85, die so angeordnet sind, dass das Behandlungsgut 10 dazwischen durchgeführt werden kann. An wenigstens einer der Walzen 84, 85 der Vorrichtung 83 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 84, 85 vorbeigeführt wird. Insbesondere kann wenigstens eine der Walzen 84, 85 erhöhte Randbereiche zum Transportieren des Behandlungsgutes 10 und eine dazwischen vorgesehene abgesetzte Rückhaltfläche aufweisen. Das Paar von Walzen 84, 85 kann beispielsweise wie die unter Bezugnahme auf Fig. 1 und 2 erläuterte Vorrichtung 1 ausgebildet sein. Wenigstens die Walze 84, 85, an der die spaltbildende Rückhaltefläche ausgebildet ist, wird so angetrieben, dass sich die Umfangsgeschwindigkeit der Walzenoberfläche an dem Spalt, d.h. entlang der Linie, an der die Walzenoberfläche durch die minimale Spalthöhe von dem Behandlungsgut 10 getrennt ist, von der Transportgeschwindigkeit des Behandlungsgutes 10 in Richtung und/oder Betrag unterscheidet.

Um ein Anstauen der Behandlungsflüssigkeit bis zu einem hohen Niveau 91 zu ermöglichen, weist die Vorrichtung 83 oberhalb der Walze 84 ein weiteres Rückhalteelement 86 auf. Das weitere Rückhalteelement 86 ist eingerichtet, um bei hohem Flüssigkeitsniveau in dem Behandlungsbereich 82 beim Anstauen der Behandlungsflüssigkeit mitzuwirken, indem es als Wand für die angestaute Flüssigkeit dient. Das weitere Rückhalteelement 86 kann beispielsweise als eine Walze ausgebildet sein, die komplementär zu der Walze 84 ausgebildet ist, so dass die Walzen 84, 86 dicht schließen und nur einen geringen oder gar keinen Durchtritt von Flüssigkeit zwischen den Walzen 84, 86 erlauben. Andere Ausgestaltungen für das weitere Element 86 sind möglich, beispielsweise in der Form einer Aufkantung.

Die Vorrichtung 83 ist so eingerichtet, dass ein Niveauunterschied 97 der Behandlungsflüssigkeit zwischen dem Niveau 91 in dem Behandlungsbereich 82 und einem Niveau 92 in dem dazu benachbarten Bereich an der anderen Seite der Vorrichtung 83 über die Vorrichtung 83 eingestellt und aufrechterhalten wird. Die in Transportrichtung der Vorrichtung 83 nachgeordnete Vorrichtung 44 entfernt weitere Behandlungsflüssigkeit von dem Behandlungsgut 10, wenn dieses die Vorrichtung 44 passiert. Anstelle des Niveaus 92 befindet sich an dem Behandlungsgut 10 nur noch eine kleinere Menge Behandlungsflüssigkeit 93, wenn das Behandlungsgut 10 das Walzenpaar der Vorrichtung 44 passiert hat. Die in Transportrichtung der Vorrichtung 44 nachgeordnete Vorrichtung 45 kann noch weitere Behandlungsflüssigkeit von dem Behandlungsgut 10 entfernen, sofern dies nach dem Durchlaufen der Vorrichtung 44 noch erforderlich ist.

Um den Niveauunterschied 97 einzustellen, sind in dem Wehr 47 verschließbare Öffnungen 61 vorgesehen. Das Niveau 92 in dem dem Behandlungsbereich 82 benachbarten Bereich wird bestimmt durch ein Gleichgewicht aus zu- und ablaufenden Strömen von Behandlungsflüssigkeit. Um diese und somit das Niveau 92 einstellen zu können, können in dem Boden 46 zwischen den Wehren 47, 48 eine oder mehrere Öffnungen 96, beispielsweise verschließbare Bohrungen, vorgesehen sein. Durch geeignete Wahl der in dem Wehr 47 geöffneten Öffnungen 61 und der in dem Boden 46 geöffneten Öffnungen 96 kann eine Grundeinstellung für ein gewünschtes Niveau 92 in dem dem Behandlungsbereich 82 benachbarten Bereich gewählt werden. Zusätzlich können an Elementen, die die Behandlungsstation seitlich begrenzen, beispielsweise an Lageraufnahmen, die für die Lagerung der Walzen der Vorrichtungen 83 und 44 vorgesehen sind, Überlaufwehre vorgesehen werden. Zusätzlich zulaufende Flüssigkeitsmengen können über die Überlaufwehre abgeführt werden.

Um den aus dem Behandlungsbereich 82 ablaufenden Strom von Behandlungsflüssigkeit auszugleichen, wird mit einer Pumpe 94 ein Strom 95 von Behandlungsflüssigkeit in den Behandlungsbereich 82 gefördert.

Während unter Bezugnahme auf Fig. 4 und 5 Ausgestaltungen von Auslaufbereichen einer Behandlungsstation beschrieben wurden, können Vorrichtungen zum Entfernen oder Abhalten von Behandlungsflüssigkeit entsprechend auch in einem Einlaufbereich einer Behandlungsstation vorgesehen werden. Insbesondere können auch in dem Einlaufbereich mehrere in Transportrichtung voneinander beabstandete Vorrichtungen zum Entfernen oder Abhalten von Behandlungsflüssigkeit vorgesehen werden, um zu verhindern, dass die Behandlungsflüssigkeit auf das Behandlungsgut strömt, bevor dieses in dem Einlaufbereich in die Behandlungsstation eingeführt wird.

Die Ausgestaltung der spaltbildenden Rückhaltefläche kann abhängig von dem spezifischen Anwendungsgebieten auf geeignete Weise gewählt werden.

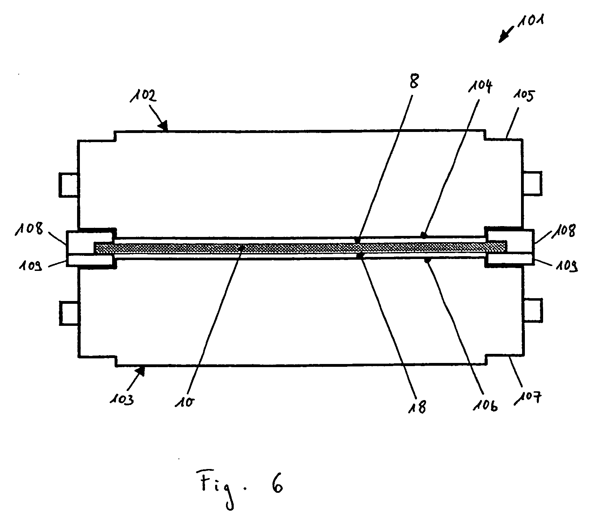

Fig. 6 ist eine schematische Vorderansicht einer Vorrichtung 101 zum Entfernen oder Abhalten von Behandlungsflüssigkeit nach einem weiteren Ausführungsbeispiel.

Die Vorrichtung 101 umfasst eine Walze 102 und eine weitere Walze 103. Die Walze 102 und die weitere Walze 103 sind so angeordnet, dass ein Behandlungsgut 10 zwischen den Walzen 102 und 103 hindurch transportiert werden kann. Eine Mantelfläche der Walze 102 weist eine Rückhaltefläche 104 auf, die zum Zurückhalten der Behandlungsflüssigkeit ausgebildet ist. Die Walze 102 mit der Rückhaltefläche 104 ist so ausgebildet, dass ein Spalt 8 zwischen der Rückhaltefläche 104 der Walze 102 und einer dieser gegenüberliegenden Oberfläche des Behandlungsgutes 10 freibleibt, wenn das Behandlungsgut 10 an der Walze 102 vorbeigeführt wird. Axiale Endabschnitte 105 der Walze 102 sind mit einem kleineren Durchmesser als der die Rückhaltefläche 104 definierende mittlere Abschnitt der Walze 102 ausgebildet, um als Transportabschnitte zum Transportieren des Behandlungsgutes 10 zu wirken, wenn dieses an seinen Längsrändern mit Halteschienen gehaltert ist.

Eine Mantelfläche der weiteren Walze 103 weist eine weitere Rückhaltefläche 106 auf, die zum Zurückhalten der Behandlungsflüssigkeit ausgebildet ist. Die weitere Walze 103 mit der weiteren Rückhaltefläche 106 ist so ausgebildet, dass ein Spalt 18 zwischen der weiteren Rückhaltefläche 106 der weiteren Walze 103 und einer dieser gegenüberliegenden Oberfläche des Behandlungsgutes 10 freibleibt, wenn das Behandlungsgut 10 an der weiteren Walze 103 vorbeigeführt wird. Axiale Endabschnitte 107 der weiteren Walze 103 sind mit einem kleineren Durchmesser als der die weitere Rückhaltefläche 106 definierende mittlere Abschnitt der weiteren Walze 103 ausgebildet, um als Transportabschnitte zum Transportieren des Behandlungsgutes 10 zu wirken, wenn dieses an seinen Längsrändern mit Halteschienen gehaltert ist.

An den Längsrändern des Behandlungsgutes 10 sind Halteschienen 108, 109 vorgesehen, die das Behandlungsgut zum Transportieren des Behandlungsgutes 10 haltern. Derartige Halteschienen 108, 109 können insbesondere beim Transportieren von Behandlungsgut mit geringer Eigensteifigkeit eingesetzt werden, um dem Behandlungsgut zusätzliche Stabilität zu verleihen. Die Walze 102 und weitere Walze 103 der Vorrichtung 101 sind so ausgestaltet, dass ihre axialen Endabschnitte 105, 107 mit kleinerem Durchmesser in Anlage mit den Halteschienen 108, 109 kommen. Durch Drehung der Walze 102 und der weiteren Walze 103 kann das Behandlungsgut 10 über die Halteschienen 108, 109 weitertransportiert werden.

Bei der Vorrichtung 101 sind die Rückhalteflächen 104, 106 der Walzen 102, 103 so gegenüber den am axialen Ende der Walzen 102, 103 vorgesehenen Transportabschnitt abgesetzt, dass Spalte 8, 18 mit gewünschter minimaler Spalthöhe zwischen den Rückhalteflächen 104, 106 und den ihnen gegenüberliegenden Oberflächen des Behandlungsgutes 10 ausgebildet werden, wenn das Behandlungsgut 10 an den Rückhalteflächen 104, 106 vorbeigeführt wird.

Bei der Vorrichtung 101 berühren die Walzen 102, 103 das Behandlungsgut 10 nicht unmittelbar. Der Transport des Behandlungsgutes 10 erfolgt über eine Kopplung der Transportabschnitte 105, 107 mit den Halteschienen 108, 109, an denen das Behandlungsgut 10 gehaltert ist.

Bei der Vorrichtung 101 weist die den Spalt 8 an einer Seite begrenzende Walzenoberfläche der Walze 102, die die Rückhaltefläche 104 bildet, eine Umfangsgeschwindigkeit auf, die kleiner als die Transportgeschwindigkeit des Behandlungsgutes 10 ist. Die den Spalt 18 an einer Seite begrenzende Walzenoberfläche der Walze 103 die die Rückhaltefläche 106 bildet, weist eine Umfangsgeschwindigkeit auf, die kleiner als die Transportgeschwindigkeit des Behandlungsgutes 10 ist.

Bei einer Abwandlung der Vorrichtung 101 können die Walzen 102, 103 so ausgebildet sein, dass sie das Behandlungsgut 10 in einem Randbereich neben den Halteschienen 108, 109 berühren, um es zu transportieren. Dazu können an den Walzen 102, 103 erhöhte Transportabschnitte vorgesehen sein, die das Behandlungsgut neben den Halteschienen 108, 109 berühren. Die Walzen 102, 103 können weiterhin so eingerichtet sein, dass auch zwischen den Walzen 102, 103 und den Halteschienen 108, 109 ein Spalt zum Verdrängen von Flüssigkeit ausgebildet wird. Dazu können relativ zu den Transportabschnitten der Walzen entsprechend zurückgesetzte Vertiefungen oder Nuten zum Abquetschen von Flüssigkeit von den Halteschienen an den Walzen 102, 103 vorgesehen werden. Der zwischen den Walzen und den Halteschienen ausgebildete Spalt kann eine minimale Spalthöhe aufweisen, die kleiner als 1 mm, insbesondere kleiner als 0,7 mm, insbesondere kleiner als 0,5 mm sein kann. Der zwischen den Walzen und den Halteschienen ausgebildete Spalt kann eine minimale Spalthöhe aufweisen, die mindestens 0,05 mm, insbesondere mindestens 0,07 mm, insbesondere mindestens 0,09 mm sein kann.

Die Vorrichtung 101 zum Abquetschen von Flüssigkeit von gehaltertem Behandlungsgut kann weiterhin auch eine Anströmeinrichtung umfassen. Die Anströmeinrichtung kann wie unter Bezugnahme auf Fig. 3 erläutert ausgebildet sein. Die Anströmeinrichtung kann insbesondere so ausgebildet sein, dass der von der Anströmeinrichtung ausgegebene Fluidstrom Behandlungsflüssigkeit auch von den Halteschienen entfernt.

In den Halteschienen 108, 109 können Durchlässe vorgesehen sein, die einen Durchtritt von Flüssigkeit durch die Halteschienen quer zur Transportrichtung ermöglichen.

Die Walzen 102, 103 können eingerichtet sein, um auf wenigstens an einem der Längsränder vorgesehene Halteschienen 108, 109 eine Kraft mit einer Kraftkomponente auszuüben, die in der Transportebene liegt und quer zur Transportrichtung gerichtet ist. Die Kraft kann so gerichtet sein, dass die an den gegenüberliegenden Längsrändern vorgesehene Halteschienen 108, 109 voneinander weg gedrückt werden, um das Behandlungsgut 10 quer zur Transportrichtung zu spannen. Dazu kann bzw. können beispielsweise die Halteschiene 108 und/oder 109 an wenigstens einem Längsrand des Behandlungsgutes einen oder mehrere Magneten, insbesondere Permanentmagneten, aufweisen. Die oberhalb der Transportebene vorgesehenen Walze 102 und/oder die unterhalb der Transportebene vorgesehene Walze 103 kann einen Magneten oder mehrere Magnete aufweisen, um auf die Halteschiene eine elektromagnetische Kraft auszuüben. Die Kraft kann so gerichtet sein, dass die Halteschienen an den gegenüberliegenden Längsrändern des Behandlungsgutes 10 federnd voneinander weg gedrückt werden.

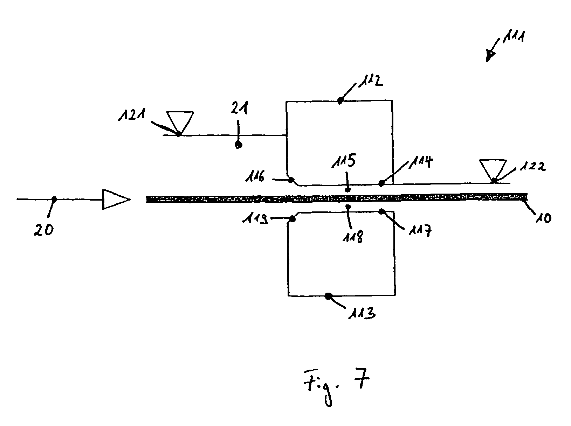

Fig. 7 ist eine schematische Seitenansicht einer Vorrichtung 111 zum Entfernen oder Abhalten von Behandlungsflüssigkeit. Bei der Vorrichtung 111 sind die Rückhalteflächen nicht an einer drehbar gelagerten Walze vorgesehen. Nach einem Ausführungsbeispiel kann die Vorrichtung 111 in Kombination mit einer Walze mit der unter Bezugnahem auf Fig. 1-6 beschriebenen Ausgestaltung in einer Behandlungsstation vorgesehen sein.

Die Vorrichtung 111 umfasst zwei im Wesentlichen quaderförmige Elemente 112, 113, die als Einsätze in einer Anlage zur Behandlung eines Behandlungsgutes 10 verwendet werden können. Der Einsatz 112 ist oberhalb der Transportebene, und der Einsatz 113 ist unterhalb der Transportebene angeordnet. Eine Oberfläche der Einsätze 112, 113 dient als Rückhaltefläche, die Behandlungsflüssigkeit zurückhält.

Die Einsätze 112, 113 der Vorrichtung 111 sind relativ zu einem Transportweg des Behandlungsgutes 10 so angeordnet, dass zwischen einer der oberen Oberfläche des Behandlungsgutes 10 und einer dieser zugewandten Seitenfläche 114 des Einsatzes 112 ein Spalt 115 freibleibt, wenn das Behandlungsgut 10 an der Vorrichtung 111 vorbeigeführt wird, und dass zwischen unteren Oberfläche des Behandlungsgutes 10 und einer dieser zugewandten Seitenfläche 117 des Einsatzes 113 ein Spalt 118 freibleibt, wenn das Behandlungsgut 10 an der Vorrichtung 111 vorbeigeführt wird. Die Seitenfläche 114 des Einsatzes 112 und die Seitenfläche 117 des Einsatzes 117 können eine planare Ausgestaltung aufweisen, so dass die Spalte 115 und 118 sich entlang der Transportrichtung mit einer konstanten Spalthöhe erstrecken.

Die Einsätze 112, 113 der Vorrichtung 111 weisen einen sich gegen die Transportrichtung 20 öffnenden Einlaufbereich auf, der durch Abschrägungen 116, 119 an den Einsätzen 112, 113 ausgebildet wird. Ein derartiger Einlaufbereich kann beispielsweise zum Führen von Behandlungsgut mit geringer Eigensteifigkeit, beispielsweise von Folien, verwendet werden.

Die Vorrichtung 111 mit den Einsätzen 112, 113 kann zum Anstauen der Behandlungsflüssigkeit 21 in einer Anlage zur elektrolytischen oder nasschemischen Behandlung des Behandlungsgutes 10 eingesetzt werden. Wenn das Behandlungsgut 10 von einem an einer ersten Seite (links in Fig. 7) der Einsätze angeordneten Behandlungsbereich, in dem die Behandlungsflüssigkeit 21 bis zu einem Niveau 121 angestaut ist, an den Einsätzen 112, 113 vorbeigeführt wird, verbleibt eine Schicht Behandlungsflüssigkeit mit einer geringeren Dicke 122 an dem Behandlungsgut 10.

Die Einsätze 112, 113 können je nach baulichen Gegebenheiten der Anlage, in denen die Vorrichtung 111 eingesetzt wird, geeignet konfiguriert werden. Beispielsweise können die Einsätze 112, 113 so ausgestaltet sein, dass die Spalte 115, 118 in der Transportrichtung 20 möglichst lang sind.

Die Einsätze 112, 113 können in der Anlage zur elektrolytischen oder nasschemischen Behandlung drehfest montiert sein. Die Einsätze 112, 113 können in der Anlage insbesondere auch an einer in Transportrichtung festgelegten Position angebracht sein. Die Einsätze 112, 113 können so angebracht sein, dass sie vertikal gegeneinander beweglich sind.

Bei einer Abwandlung der Vorrichtung 111 ist oberhalb der Transportebene ein quaderförmiger Einsatz vorgesehen, während unterhalb der Transportebene eine Walze zum Transportieren des Behandlungsgutes vorgesehen ist. Der quaderförmige Einsatz kann beispielsweise dieselbe Ausgestaltung wie der Einsatz 112 der Vorrichtung 111 aufweisen.

Fig. 8 ist eine schematische Seitenansicht einer Behandlungsstation 131, in dem in einem Einlaufbereich ein Paar von Walzen 132, 133 und in einem Auslaufbereich ein weiteres Paar von Walzen 134, 135 vorgesehen ist. Die Walze 132 im Einlaufbereich ist oberhalb der Transportebene und die Walze 133 im Einlaufbereich ist unterhalb der Transportebene eines Behandlungsgutes 10 angeordnet. Die Walze 134 im Auslaufbereich ist oberhalb der Transportebene und die Walze 135 im Auslaufbereich ist unterhalb der Transportebene eines Behandlungsgutes 10 angeordnet. Mit den Walzenpaaren wird die Behandlungsflüssigkeit 21 in der Behandlungsstation 131 bis zu einem Niveau 136 angestaut.

Jede der Walzen 132-135 weist an ihren axialen Enden Transportabschnitte in der Form von Erhöhungen 5, 15 zum Transportieren des Behandlungsgutes auf. Zwischen den an den Enden vorgesehenen Transportabschnitten ist eine Rückhaltefläche 4, 14 mit kleinerem Durchmesser ausgebildet. Wie unter Bezugnahme auf Fig. 1 und 2 erläutert, bildet die als Rückhaltefläche 4, 14 ausgestaltete Oberfläche der Walzen einen Spalt mit dem an den Walzen vorbeigeführten Behandlungsgut aus, der sich in der Breitenrichtung des Behandlungsgutes erstreckt.

Die verschiedenen Abschnitte der Walze 132 im Einlaufbereich werden so drehend angetrieben, dass sich die Transportabschnitte 5 und die dazwischen angeordnete Rückhaltefläche 4 der oberhalb der Transportebene vorgesehenen Walze 132 gleichsinnig drehen. Die verschiedenen Abschnitte der Walze 133 im Einlaufbereich werden so drehend angetrieben, dass sich die Transportabschnitte 15 und die dazwischen angeordnete Rückhaltefläche 14 der unterhalb der Transportebene vorgesehenen Walze 133 gleichsinnig drehen. Die Drehrichtung 141 der Transportabschnitte 5 der oberhalb der Transportebene vorgesehenen Walze 132 ist so gewählt, dass sich die Transportabschnitte 5 an ihren Berührungspunkten mit dem Behandlungsgut 10 in der Transportrichtung 20 bewegen, um das Behandlungsgut 10 in der Transportrichtung 20 zu transportieren. Die Drehrichtung 143 der Transportabschnitte 15 der unterhalb der Transportebene vorgesehenen Walze 133 ist so gewählt, dass sich die Transportabschnitte 15 an ihren Berührungspunkten mit dem Behandlungsgut 10 in der Transportrichtung 20 bewegen, um das Behandlungsgut 10 in der Transportrichtung 20 zu transportieren. Die Rückhaltefläche 4 der oberhalb der Transportebene vorgesehenen Walze 132 wird gleichsinnig mit den Transportabschnitten 5 der Walze 132 in einer Drehrichtung 142 so gedreht, dass sich der Abschnitt der Rückhaltefläche 4, der gerade zu dem Behandlungsgut 10 zeigt, in Richtung des höheren Flüssigkeitsniveaus (in Fig. 8 nach rechts) bewegt. Ähnlich wird die Rückhaltefläche 14 der unterhalb der Transportebene vorgesehenen Walze 133 gleichsinnig mit den Transportabschnitten 15 in einer Drehrichtung 144 so gedreht, dass sich der Abschnitt der Rückhaltefläche 14, der gerade zu dem Behandlungsgut 10 zeigt, in Richtung des höheren Flüssigkeitsniveaus (in Fig. 8 nach rechts) bewegt.

Durch geeignete Ausgestaltung der Walzen 132, 133 kann ein ausreichend hohes Flüssigkeitsniveau 136 angestaut werden, während die Bewegung der Rückhalteflächen 4 gegen den Bereich mit dem hohen Flüssigkeitsniveau den Durchtritt von Flüssigkeit durch die an den Rückhalteflächen 4 der Walzen 132, 133 ausgebildete Spalte ausreichend verringert. Dazu können die Walzen 132, 133 so ausgestaltet sein, dass ein Spalt mit einer minimalen Spalthöhe von weniger als 0,3 mm, beispielsweise ca. 0,1 mm zwischen der Rückhaltefläche 4, 14 und der der Rückhaltefläche gegenüberliegenden Oberfläche des Behandlungsgutes 10 ausgebildet wird. Beispielsweise können die Transportabschnitte um weniger als 0,3 mm, beispielsweise um ca. 0,1 mm, relativ zu der Rückhaltefläche erhöht sein.

Im Auslaufbereich werden die Transportabschnitte 5, 15 der Walzen 134, 135 mit einer Drehrichtung 145, 147 so gedreht, dass sich die Transportabschnitte 5, 15 an ihren Berührungspunkten mit dem Behandlungsgut 10 in der Transportrichtung 20 bewegen.

Um mit den Walzen 134, 135 im Auslaufbereich den Durchtritt von Flüssigkeit durch die im Auslaufbereich gebildeten Spalte zu verringern, kann die oberhalb der Transportebene vorgesehene Walze 134 so ausgebildet sein, dass die Rückhaltefläche 4 der Walze 134 relativ zu dem Transportabschnitt 5 der Walze 134 drehbar ist. Ähnlich kann die unterhalb der Transportebene vorgesehene Walze 135 so ausgebildet sein, dass die Rückhaltefläche 14 der Walze 135 relativ zu dem Transportabschnitt 15 der Walze 135 drehbar ist. Im Auslaufbereich kann die Rückhaltefläche 4 der oberhalb der Transportebene vorgesehenen Walze 134 in einer Drehrichtung 146 gedreht werden, die gegensinnig zur Drehrichtung 145 des Transportabschnitts 5 dieser Walze 134 ist. Die Rückhaltefläche 14 der unterhalb der Transportebene vorgesehenen Walze 135 kann in einer Drehrichtung 148 gedreht werden, die gegensinnig zur Drehrichtung 147 des Transportabschnitts 15 dieser Walze 135 ist. Auf diese Weise kann auch im Auslaufbereich eine Drehung der Rückhalteflächen 4, 14 derart erfolgen, dass sich der Abschnitt der Rückhaltefläche 4 der oberhalb der Transportebene vorgesehenen Walze 134, der gerade zu dem Behandlungsgut 10 zeigt, in Richtung des höheren Flüssigkeitsniveaus (in Fig. 8 nach links) bewegt. Ähnlich kann die Rückhaltefläche 14 der Walze 135 gegensinnig zu dem Transportabschnitt 15 so gedreht werden, dass sich der Abschnitt der Rückhaltefläche 14 der Walze 135, der gerade zu dem Behandlungsgut 10 zeigt, in Richtung des höheren Flüssigkeitsniveaus (in Fig. 8 nach links) bewegt.

Die als Rückhaltefläche 4 dienende Walzenoberfläche der Walze 134 wird dabei so gedreht, dass sich die der Transportebene nächsten Punkte der Walzenoberfläche in einer Richtung (in Fig. 8 nach links) entgegengesetzt zu der Transportrichtung des Behandlungsgutes 10 bewegen. Auf diese Weise wird eine Relativbewegung zwischen der Walzenoberfläche 4 an der oberen Kante des Spaltes 8 und dem Behandlungsgut 10 erzeugt. Die als Rückhaltefläche 5 dienende Walzenoberfläche der Walze 135 wird so gedreht, dass sich die der Transportebene nächsten Punkte der Walzenoberfläche in einer Richtung (in Fig. 8 nach links) entgegengesetzt zu der Transportrichtung des Behandlungsgutes 10 bewegen. Auf diese Weise wird eine Relativbewegung zwischen der Walzenoberfläche an der unteren Kante des Spaltes 9 und dem Behandlungsgut 10 erzeugt.

Auch die Walzen 134, 135 im Auslaufbereich können so ausgestaltet sein, dass ein Spalt mit einer minimalen Spalthöhe von weniger als 0,3 mm, beispielsweise ca. 0,1 mm zwischen der Rückhaltefläche 4, 14 und der der Rückhaltefläche gegenüberliegenden Oberfläche des Behandlungsgutes 10 ausgebildet wird. Beispielsweise können die Transportabschnitte um weniger als 0,3 mm, beispielsweise um ca. 0,1 mm, relativ zu der Rückhaltefläche erhöht sein.

Alternativ oder zusätzlich kann bzw. können im Einlaufbereich und/oder im Auslaufbereich der Behandlungsstation 131 jeweils eine oder mehrere Anströmeinrichtungen vorgesehen sein, um durch die Spalte austretende Behandlungsflüssigkeit mit einem Fluidstrom zu entfernen, wie unter Bezugnahme auf Fig. 3 erläutert.

Durch geeignete Ausgestaltung der Walzenpaare im Einlaufbereich und/oder Auslaufbereich ist es möglich, einen Austritt von Flüssigkeit durch die Spalte, die beim Transportieren des Behandlungsgutes freibleiben, so zu verringern, dass im Einlaufbereich und/oder im Auslaufbereich der Behandlungsstation keine Anströmeinrichtung zum Abblasen von Behandlungsflüssigkeit vorgesehen wird.

Im Einlaufbereich und/oder im Auslaufbereich können auch jeweils mehrere Vorrichtungen zum Entfernen oder Abhalten von Behandlungsflüssigkeit vorgesehen sein, wie unter Bezugnahme auf Fig. 4 und 5 erläutert.

Die Vorrichtungen und Verfahren nach verschiedenen Ausführungsbeispielen erlauben es, in einer Anlage zur elektrolytischen oder nasschemischen Behandlung von Behandlungsgut eine Behandlungsflüssigkeit von dem Behandlungsgut zu entfernen oder abzuhalten oder den Stoffaustausch an dem Behandlungsgut zu erhöhen, wobei ein direkter Kontakt zwischen festen Elementen und einem Nutzbereich des Behandlungsgutes verringert oder vermieden werden kann.

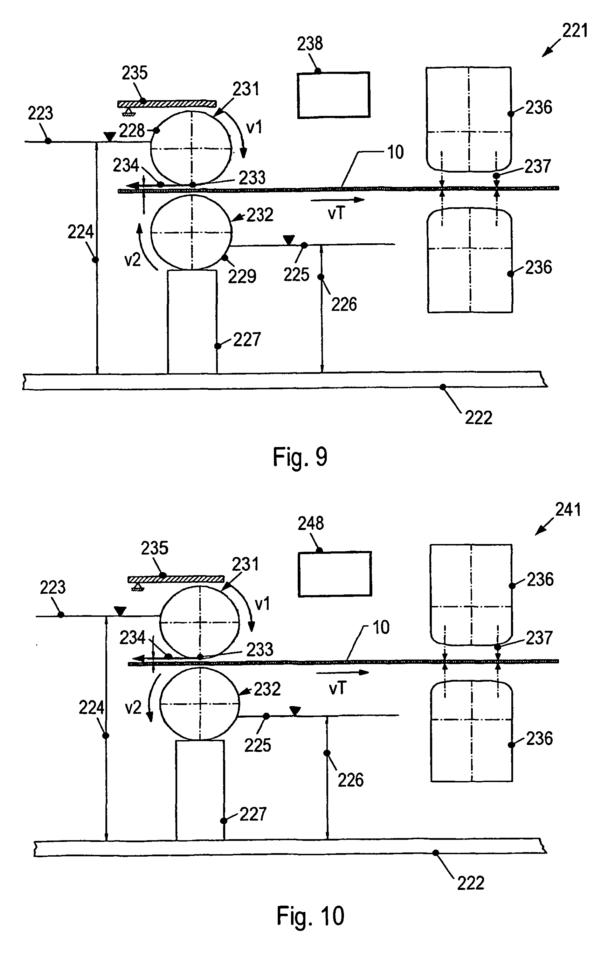

Fig. 9 ist eine teilweise geschnittene Seitenansicht eines Auslaufbereichs 221 einer Behandlungsstation. Die dargestellte Vorrichtung zum Entfernen von Flüssigkeit kann ein Paar von Walzen 231, 232, eine Abstreifeinrichtung 235, eine Anströmeinrichtung 236 und eine Antriebseinrichtung 238 umfassen. Die Vorrichtung kann beispielsweise anstelle der Abquetschwalzen 214 und/oder 215 bei der Behandlungsstation 200 von Fig. 18 eingesetzt werden.

Die Behandlungsstation weist eine Innenwanne mit einem Boden 222 auf. Die Behandlungsflüssigkeit weist in einem Bereich der Behandlungsstation ein Betriebsniveau 223 mit einer Höhe 224 gegenüber dem Boden 222 auf. Das Betriebsniveau 223 ist so eingestellt, dass das Behandlungsgut 10 von der Behandlungsflüssigkeit überdeckt ist, bevor es das Paar von Walzen 231, 232 passiert. Wie bereits unter Bezugnahme auf Fig. 4 und 5 beschrieben wurde, kann durch ein Wehr 227 in Kombination mit dem Paar von Walzen 231, 232 erreicht werden, dass die Behandlungsflüssigkeit stromabwärts des Wehrs 227 nur noch ein Niveau 225 unterhalb der Transportebene des Behandlungsgutes 10 erreicht. Die Höhe 226 der Behandlungsflüssigkeit stromabwärts des Wehrs 227 ist kleiner als die Höhe 224 stromaufwärts des Wehrs.

Die Walzen 231, 232 sind so ausgestaltet, dass sie jedenfalls von dem Nutzbereich des Behandlungsgutes 10 beabstandet sind, der sich kontinuierlich zwischen gegenüberliegenden Randabschnitten erstreckt. Die Walze 231 ist oberhalb der Transportebene des Behandlungsgutes angeordnet. Die Walze 232 ist unterhalb der Transportebene des Behandlungsgutes angeordnet. Jede der Walzen 231, 232 ist wenigstens an einem Teil ihres Umfangs mit Behandlungsflüssigkeit überdeckt. Die Walzen 231, 232 können so ausgebildet sein, dass sie von dem gesamten Behandlungsgut 10 beabstandet sind, wenn das Behandlungsgut 10 an den Walzen 231, 232 vorbeigeführt wird. Insbesondere können die Walzen 231, 232 so ausgestaltet sein, dass sie nicht beim Transport des Behandlungsgutes 10 mitwirken. Die Walzen 231, 232 können eine zylindrische Walzenoberfläche 228 bzw. 229 aufweisen. Ein Spalt zwischen der Walzenoberfläche 228 der Walze 231 und dem Behandlungsgut 10 erstreckt sich kontinuierlich zwischen Randbereichen des Behandlungsgutes 10 in einer Breitenrichtung. Ein weiterer Spalt zwischen der Walzenoberfläche 229 der Walze 232 und dem Behandlungsgut 10 erstreckt sich kontinuierlich zwischen Randbereichen des Behandlungsgutes 10 in der Breitenrichtung.

Die Walzen 231, 232 werden von der Antriebseinrichtung 238 drehend angetrieben. Die Antriebseinrichtung kann einen Aktuator, beispielsweise einen Motor, und geeignete Komponenten zum Übertragen des Drehmoments von dem Aktuator zu den Walzen 231, 232 umfassen. Die Antriebseinrichtung 238 für die Walzen 231, 232 kann Komponenten aufweisen, die gleichzeitig Bestandteil von Antriebseinrichtungen für andere Elemente, beispielsweise für Transportwalzen, sind. Vorteilhaft kann die Antriebseinrichtung 238 innerhalb der Behandlungsstation vorgesehen sein. Wenigstens der Motor der Antriebseinrichtung 238 kann gekapselt sein.

Die Antriebseinrichtung 238 treibt die Walze 231 so an, dass diese eine Umfangsgeschwindigkeit mit einem Betrag v1 aufweist. Entlang der Linie 233, an der die Walzenoberfläche 228 der Walze 231 um die Spalthöhe von dem Nutzbereich des Behandlungsgutes 10 beabstandet ist, ist der Geschwindigkeitsvektor 234 der Umfangsgeschwindigkeit entgegen der Transportgeschwindigkeit vT des Behandlungsgutes gerichtet. Aufgrund des viskosen Widerstands zwischen der Walze 231 und der Behandlungsflüssigkeit kann der Austritt von Behandlungsflüssigkeit durch den Spalt verringert werden. Allgemein kann in einem Einlauf- oder Auslaufbereich einer Behandlungsstation die oberhalb der Transportebene angeordnete Walze 231 so angetrieben werden, dass sich die Walzenoberfläche an der den Spalt begrenzende Linie in Richtung des höheren Niveaus bewegt. Der Betrag der Geschwindigkeit v1 bzw. die Drehzahl der Walze 231 kann abhängig von einem gewünschten Niveauunterschied der Behandlungsflüssigkeit zwischen den beiden Seiten der Walze eingestellt werden.

Die Antriebseinrichtung 238 treibt die Walze 232 so an, dass diese eine Umfangsgeschwindigkeit mit einem Betrag v2 aufweist. Die Walze 231 und die Walze 232 werden so angetrieben, dass sie sich gleichsinnig drehen. Bei einer Ausgestaltung kann die Umfangsgeschwindigkeit v2 der zweiten Walze 232 betragsmäßig gleich der Transportgeschwindigkeit des Behandlungsgutes, vT, ± 20% sein. Dadurch kann das Risiko, dass ein Behandlungsgut 10 mit geringer Eigensteifigkeit so stark ausgelenkt wird, dass es mit einer der Walzen 231, 232 in unzulässigen Kontakt kommt, verringert werden. Die Walze 232 kann auch derart angetrieben werden, dass der Betrag der Umfangsgeschwindigkeit v2 größer als der Betrag der Transportgeschwindigkeit vT ist.

Bei einer Ausführungsform werden die Walzen 231, 232 so angetrieben, dass v1=v2.

Die Antriebseinrichtung 238 kann die Walze 231 so antreiben, dass die Walze 231 Behandlungsflüssigkeit mitnimmt. Die Menge der mitgenommenen Behandlungsflüssigkeit ist abhängig von Oberflächeneigenschaften der Walze 231, insbesondere von einer Oberflächenrauhigkeit, von der Drehgeschwindigkeit und dem Durchmesser der Walze 231.

Die Abstreifeinrichtung 235 entfernt mitgenommene Behandlungsflüssigkeit von der Walze 231. Die Abstreifeinrichtung 235 kann beispielsweise als Leiste ausgebildet sein, die sich parallel zu der Achse der Walze 231 erstreckt. Die Abstreifeinrichtung 235 kann so ausgebildet sein, dass sie eine Variation der von der Walze 231 mitgenommenen Behandlungsflüssigkeit entlang der Axialrichtung der Walze 231 ausgleicht. Beispielsweise kann die Abstreifeinrichtung 235 entlang der Axialrichtung der Walze 231 einen konstanten Abstand von der Walzenoberfläche 228 aufweistn. Die Abstreifeinrichtung 231 kann so ausgebildet sein, dass sie die Behandlungsflüssigkeit nicht vollständig von der Walze 231 entfernt, so dass sich aufgrund der Rotation der Walze 231 ein Film der Behandlungsflüssigkeit mit endlicher Dicke um die Walze 231 ausbildet. Die Abstreifeinrichtung 235 kann so ausgebildet sein, dass der Film der Behandlungsflüssigkeit um die Walze 231 den effektiven Querschnitt des Spaltes zwischen der Walze 231 und dem Behandlungsgut 10 für den Austritt von Behandlungsflüssigkeit reduziert.

Die Abstreifeinrichtung 235 kann relativ zu der Walze 231 verstellbar sein, um die Menge der von der Abstreifeinrichtung 235 zurückgehaltenen Behandlungsflüssigkeit einzustellen. Auf diese Weise kann die Menge zurückgehaltener Behandlungsflüssigkeit abhängig von dem Anwendungsfall, beispielsweise abhängig von dem gewünschten Niveau 223, eingestellt werden.

Die Anströmeinrichtung 236 strömt das Behandlungsgut 10 mit einem Fluid 237, beispielsweise mit Luft, an. Behandlungsflüssigkeit, die sich nach dem Durchtritt des Behandlungsgutes 10 zwischen den Walzen 231, 232 noch an dem Behandlungsgut 10 befindet, kann so entfernt werden. Die Anströmeinrichtung kann wie unter Bezugnahme auf Fig. 3-5 beschrieben ausgebildet sein.

Fig. 10 ist eine teilweise geschnittene Seitenansicht eines Auslaufbereichs 241 einer Behandlungsstation mit einer Vorrichtung zum Entfernen von Behandlungsflüssigkeit. Die Vorrichtung zum Entfernen von Behandlungsflüssigkeit umfasst ein Paar von Walzen 231, 232, eine Abstreifeinrichtung 235, eine Anströmeinrichtung 236 und eine Antriebseinrichtung 248. Die Vorrichtung kann beispielsweise anstelle der Abquetschwalzen 214 und/oder 214 bei der Behandlungsstation 200 von Fig. 18 eingesetzt werden. Elemente und Einrichtungen, die in ihrer Ausgestaltung und/oder Funktion Elementen und/oder Einrichtungen des Auslaufbereichs 221 entsprechen und unter Bezugnahme auf Fig. 9 beschrieben wurden, sind mit den gleichen Bezugszeichen wie in Fig. 9 bezeichnet.

Die Antriebseinrichtung 248 ist so ausgestaltet, dass sich die Walze 232 gegensinnig zu der Walze 231 dreht. Die Oberfläche der Walze 232 weist eine Umfangsgeschwindigkeit mit einem Betrag v2 auf. Entlang der Linie, an der die Walze 232 um die minimale Spalthöhe von dem Behandlungsgut 10 beabstandet ist, ist die Umfangsgeschwindigkeit entgegen der Transportrichtung des Behandlungsgutes gerichtet. Aufgrund des viskosen Widerstands zwischen der Walze 232 und der Behandlungsflüssigkeit kann der Austritt von Behandlungsflüssigkeit durch den Spalt zwischen der Walze 232 und dem Behandlungsgut verringert werden. Insbesondere für Behandlungsgut 10 mit ausreichender Eigensteifigkeit, beispielsweise für eine Leiterplatte mit hoher Eigensteifigkeit, können die Walzen v1, v2 wie in Fig. 10 dargestellt gegensinnig gedreht werden.

Der Betrag der Umfangsgeschwindigkeit v2 der Walze 232 kann beispielsweise abhängig davon gewählt werden, welcher Flüssigkeitsstrom durch den Spalt zwischen der Walze 232 und dem Behandlungsgut 10 toleriert wird. Durch eine Umfangsgeschwindigkeit mit größerem Betrag v2 kann die pro Zeiteinheit austretende Menge der Behandlungsflüssigkeit verringert werden. Bei einer Ausführungsform werden die Walzen 231, 232 so angetrieben, dass v1=v2.

Während unter Bezugnahme auf Fig. 9 und 10 Vorrichtungen mit einem Paar von Walzen beschrieben wurden, können bei weiteren Ausführungsformen mehrere Paare von Walzen, wie sie unter Bezugnahme auf Fig. 9 und 10 beschrieben wurden, in einem Auslaufbereich einer Behandlungsstation vorgesehen sein. Beispielsweise können mehrere derartige Paare von Walzen wie unter Bezugnahme auf Fig. 4 und 5 beschrieben in Transportrichtung voneinander beabstandet vorgesehen sein. Auf diese Weise kann eine Niveaukaskade erreicht werden. Alternativ oder zusätzlich kann das Paar von Walzen mit einer in Transportrichtung dazu beabstandet angeordneten Vorrichtung mit feststehenden Elementen, wie sie beispielsweise in Fig. 7 gezeigt ist, kombiniert werden.

Während unter Bezugnahme auf Fig. 9 und 10 Vorrichtungen mit einem Paar von Walzen beschrieben wurden, kann bei weiteren Ausführungsformen anstelle einer der Walzen, beispielsweise anstelle der unterhalb der Transportebene vorgesehenen Walze 232, ein feststehendes Element vorgesehen sein. Bei weiteren Ausführungsformen muss nicht sowohl die Walze 231 als auch die Walze 232 von dem Behandlungsgut 10 beabstandet sein. Falls die einer Walze zugewandte Seite des Behandlungsgutes berührungsempfindlich ist, ist nach Ausführungsformen die Walze von dem Behandlungsgut beabstandet vorgesehen.

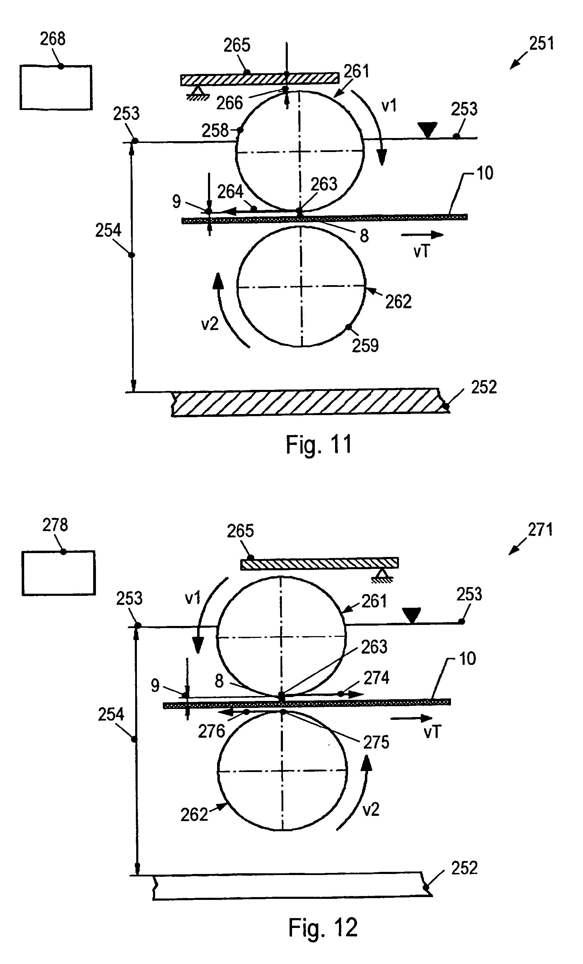

Während im Kontext von Ausführungsbeispielen die Verwendung von Vorrichtungen zum Entfernen oder Abhalten von Behandlungsflüssigkeit in einem Einlaufbereich und/oder in einem Auslaufbereich eines Innenbereichs einer Behandlungsstation beschrieben wurde, kann eine derartige Vorrichtung auch beabstandet von Ein- und Auslaufbereich einer Behandlungsstation eingesetzt werden, um Flüssigkeit zu verdrängen, beispielsweise für einen verbesserten Stoffaustausch, wie unter Bezugnahme auf Fig. 11-17 näher beschrieben wird. Mit den verschiedenen unter Bezugnahme auf Fig. 11-17 näher beschriebenen Vorrichtungen können ebene Oberflächen des Behandlungsgutes, aber vorteilhaft auch Sacklöcher oder Durchgangslöcher behandelt werden. Die unter Bezugnahme auf Fig. 11-17 beschriebenen Vorrichtungen können in einer Behandlungsstation in Kombination mit oder anstelle von Anströmdüsen eingesetzt werden. Falls die Vorrichtungen anstelle von Anströmdüsen eingesetzt werden, wird durch einen geeigneten Mechanismus Behandlungsflüssigkeit in den Innenbereich der Behandlungsstation gefördert.

Fig. 11 ist eine teilweise geschnittene Seitenansicht eines Behandlungsabschnitts 251 einer Behandlungsstation. Der Abschnitt 251 weist ein Paar von Walzen 261, 262, eine Abstreifeinrichtung 265 und eine Antriebseinrichtung 268 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 eingesetzt werden.

Die Behandlungsstation weist eine Innenwanne mit einem Boden 252 auf. Die Behandlungsflüssigkeit weist in einem Bereich der Behandlungsstation ein Betriebsniveau 253 mit einer Höhe 254 auf. Das Betriebsniveau 253 ist so eingestellt, dass das Behandlungsgut 10 in einer Umgebung der Walzen 261, 262 von der Behandlungsflüssigkeit überdeckt ist.

Die Walzen 261, 262 sind so ausgestaltet, dass sie jedenfalls von dem Nutzbereich des Behandlungsgutes 10 beabstandet sind, der sich zwischen gegenüberliegenden Randabschnitten erstreckt. Die Walze 261 ist oberhalb der Transportebene des Behandlungsgutes angebracht. Die Walze 262 ist unterhalb der Transportebene des Behandlungsgutes angebracht. An den in Transportrichtung entgegengesetzten Seiten der Walze 261 steht die Behandlungsflüssigkeit bis zu dem Betriebsniveau 253 an. Die Walze 262 ist vollständig unterhalb des Niveaus 253 angeordnet.

Die Walzen 261, 262 können so ausgebildet sein, dass sie von dem gesamten Behandlungsgut 10 beabstandet sind, wenn das Behandlungsgut 10 an den Walzen 261, 262 vorbeigeführt wird. Insbesondere können die Walzen 261, 262 so ausgestaltet sein, dass sie nicht beim Transport des Behandlungsgutes 10 mitwirken. Die Walzen 261, 262 können eine zylindrische Oberfläche 258 bzw. 259 aufweisen. Ein Spalt 8 zwischen der Walze 261 und dem Behandlungsgut 10 mit einer Spalthöhe 9 erstreckt sich kontinuierlich zwischen Randbereichen des Behandlungsgutes 10 in einer Breitenrichtung. Ein weiterer Spalt zwischen der Walze 262 und dem Behandlungsgut 10 erstreckt sich kontinuierlich zwischen den Randbereichen des Behandlungsgutes 10 in der Breitenrichtung.

Die Walzen 261, 262 werden von der Antriebseinrichtung 268 drehend angetrieben. Die Antriebseinrichtung kann einen Aktuator, beispielsweise einen Motor, und geeignete Komponenten zum Übertragen des Drehmoments vom Aktuator zu den Walzen 261, 262 umfassen. Die Antriebseinrichtung 268 für die Walzen 261, 262 kann Komponenten aufweisen, die gleichzeitig Bestandteil von Antriebseinrichtungen für andere Elemente, beispielsweise für Transportwalzen, sind.

Die Antriebseinrichtung 268 treibt die Walze 261 so an, dass die Walzenoberfläche 258 eine Umfangsgeschwindigkeit mit einem Betrag v1 aufweist. Entlang der Linie 263, die die durch die Walzenoberfläche gebildete Begrenzung des Spalts zwischen der Walze 261 und dem Behandlungsgut 10 darstellt, ist der Geschwindigkeitsvektor 264 der Umfangsgeschwindigkeit entgegen der Transportgeschwindigkeit vT des Behandlungsgutes gerichtet. Die Walzenoberfläche der Walze 261 und das Behandlungsgut 10 bewegen sich an den Rändern des Spaltes 8 mit einer Relativgeschwindigkeit. Der Stoffaustausch an der der Walze 261 zugewandten Oberfläche des Behandlungsgutes 10 kann so wirksam gefördert werden. Die Antriebseinrichtung 238 treibt die Walze 262 so an, dass diese eine Umfangsgeschwindigkeit mit einem Betrag v2 aufweist.

Die Walze 261 und die Walze 262 werden von der Antriebseinrichtung 268 so angetrieben, dass sie sich gleichsinnig drehen. Insbesondere kann die unter der Transportebene angeordnete Walze 262 so angetrieben werden, dass sich die Walzenoberfläche entlang der Linie, an der die Walze 262 um die Spalthöhe von dem Behandlungsgut 10 beabstandet ist, in Richtung der Transportgeschwindigkeit vT des Behandlungsgutes 10 bewegt.

Eine Abstreifeinrichtung 265 ist vorgesehen, um Behandlungsflüssigkeit von der Walze 261 abzustreifen. Ein Abstand 266 zwischen der Abstreifeinrichtung 265 und der Walze 261 kann einstellbar sein. Auf diese Weise kann die von der Abstreifeinrichtung 265 zurückgehaltene Menge von Behandlungsflüssigkeit eingestellt werden. Die Ausgestaltung und Funktionsweise der Abstreifeinrichtung 265 entspricht der für die Abstreifeinrichtung 235 beschriebenen Ausgestaltung und Funktionsweise. Insbesondere kann die Abstreifeinrichtung so eingestellt werden, dass die Walze 261 vollständig mit einem Film der Behandlungsflüssigkeit umgeben ist.

Fig. 12 ist eine teilweise geschnittene Seitenansicht eines Behandlungsabschnitts 271 einer Behandlungsstation. Der Abschnitt 271 weist ein Paar von Walzen 261, 262, eine Abstreifeinrichtung 265 und eine Antriebseinrichtung 278 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 eingesetzt werden. Elemente und Einrichtungen, die in ihrer Ausgestaltung und/oder Funktion Elementen und/oder Einrichtungen des Abschnitts 251 entsprechen und unter Bezugnahme auf Fig. 11 beschrieben wurden, sind mit den gleichen Bezugszeichen wie in Fig. 11 bezeichnet.

Die Antriebseinrichtung 278 treibt die Walzen 261, 262 so an, dass sie gleichsinnig rotieren. Entlang der Linie 263, an der die Walze 261 um die Spalthöhe 9 von dem Nutzbereich des Behandlungsgutes 10 beabstandet ist, bewegt sich die Walzenoberfläche der Walze 261 mit einer Geschwindigkeit 274, die in Transportrichtung des Behandlungsgutes 10 gerichtet ist. Der Betrag der Umfangsgeschwindigkeit v1 kann so eingestellt werden, dass er von dem Betrag der Transportgeschwindigkeit vT verschieden ist. Entlang der Linie 275, an der die Walze 262 um die Spalthöhe des Spaltes zwischen der Walze 262 und dem Behandlungsgut 10 von dem Nutzbereich des Behandlungsgutes 10 beabstandet ist, bewegt sich die Walzenoberfläche der Walze 262 mit einer Geschwindigkeit 276, die entgegen der Transportrichtung des Behandlungsgutes 10 gerichtet ist. Dies führt zu einer Relativgeschwindigkeit zwischen der Walzenoberfläche der Walze 262 und dem Behandlungsgut 10 an dem Spalt.

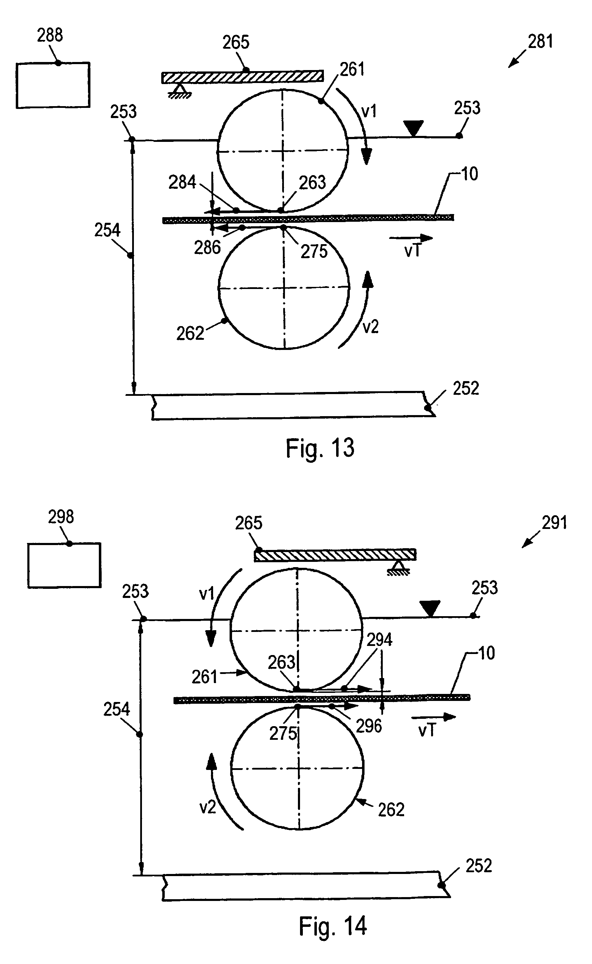

Bei weiteren Ausführungsformen kann die Antriebseinrichtung so ausgebildet sein, dass die oberhalb der Transportebene vorgesehene Walze 261 und die unterhalb der Transportebene vorgesehene Walze 262 gegensinnig gedreht werden, wie unter Bezugnahme auf Fig. 13 und 14 beschrieben werden wird.

Fig. 13 ist eine teilweise geschnittene Seitenansicht eines Behandlungsabschnitts 281 einer Behandlungsstation. Der Abschnitt 281 weist ein Paar von Walzen 261, 262, eine Abstreifeinrichtung 265 und eine Antriebseinrichtung 288 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 oder in Kombination mit den Anströmdüsen eingesetzt werden. Elemente und Einrichtungen, die in ihrer Ausgestaltung und/oder Funktion Elementen und/oder Einrichtungen des Abschnitts 251 oder des Abschnitts 271 entsprechen und unter Bezugnahme auf Fig. 11 oder Fig. 12 beschrieben wurden, sind mit den gleichen Bezugszeichen wie in Fig. 11 oder Fig. 12 bezeichnet.

Die Antriebseinrichtung 288 treibt die Walzen 261, 262 so an, dass sie gegensinnig rotieren. Entlang der Linie 263, an der die Walze 261 um die Spalthöhe 9 von dem Nutzbereich des Behandlungsgutes 10 beabstandet ist, bewegt sich die Walzenoberfläche der Walze 261 mit einer Geschwindigkeit 284, die entgegen der Transportrichtung des Behandlungsgutes 10 gerichtet ist. Entlang der Linie 275, an der die Walze 262 um die Spalthöhe des Spaltes zwischen der Walze 262 und dem Behandlungsgut von dem Nutzbereich des Behandlungsgutes 10 beabstandet ist, bewegt sich die Walzenoberfläche der Walze 262 mit einer Geschwindigkeit 286, die entgegen der Transportrichtung des Behandlungsgutes 10 gerichtet ist. Dadurch wird sowohl an dem Spalt, der zwischen dem Nutzbereich des Behandlungsgutes 10 und der Walze 261 freibleibt, als auch an dem weiteren Spalt, der zwischen dem Nutzbereich des Behandlungsgutes 10 und der Walze 262 freibleibt, eine Relativgeschwindigkeit zwischen dem Behandlungsgut und der den Spalt begrenzenden Walze 261 bzw. 262 hervorgerufen. Der Stoffaustausch kann an beiden Seiten des Behandlungsgutes wirksam gefördert werden.

Fig. 14 ist eine teilweise geschnittene Seitenansicht eines Behandlungsabschnitts 291 einer Behandlungsstation. Der Abschnitt 291 weist ein Paar von Walzen 261, 262, eine Abstreifeinrichtung 265 und eine Antriebseinrichtung 298 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 oder in Kombination mit den Anströmdüsen einer Behandlungsstation eingesetzt werden. Elemente und Einrichtungen, die in ihrer Ausgestaltung und/oder Funktion Elementen und/oder Einrichtungen des Abschnitts 251 oder des Abschnitts 271 entsprechen und unter Bezugnahme auf Fig. 11 oder Fig. 12 beschrieben wurden, sind mit den gleichen Bezugszeichen wie in Fig. 11 oder Fig. 12 bezeichnet.

Die Antriebseinrichtung 298 treibt die Walzen 261, 262 so an, dass sie gegensinnig rotieren. Entlang der Linie 263, an der die Walze 261 um die Spalthöhe 9 von dem Nutzbereich des Behandlungsgutes 10 beabstandet ist, bewegt sich die Walzenoberfläche der Walze 261 mit einer Geschwindigkeit 294, die in der Transportrichtung des Behandlungsgutes 10 gerichtet ist. Entlang der Linie 275, an der die Walze 262 um die Spalthöhe des Spaltes zwischen der Walze 262 und dem Behandlungsgut von dem Nutzbereich des Behandlungsgutes 10 beabstandet ist, bewegt sich die Walzenoberfläche der Walze 262 mit einer Geschwindigkeit 296, die ebenfalls in der Transportrichtung des Behandlungsgutes 10 gerichtet ist.

Der Betrag der Geschwindigkeit 294 entspricht der Umfangsgeschwindigkeit v1 der Walze 261. Der Betrag der Geschwindigkeit 296 entspricht der Umfangsgeschwindigkeit v2 der Walze 262. Wenigstens eine der Umfangsgeschwindigkeiten v1 und v2 ist von dem Betrag der Transportgeschwindigkeit vT des Behandlungsgutes 10 verschieden. Dadurch wird eine Relativgeschwindigkeit zwischen der entsprechenden Walze und dem Behandlungsgut hervorgerufen.

Bei weiteren Ausführungsformen kann auch nur eine Walze als Behandlungsorgan vorgesehen sein. Die Walze kann oberhalb der Transportebene oder unterhalb der Transportebene vorgesehen sein. Behandlungsorgane in Form einer Walze, die keine Gegenwalze an der anderen Seite der Transportebene aufweisen, können insbesondere zur Behandlung von Durchgangslöchern oder Sacklöchern eingesetzt werden.

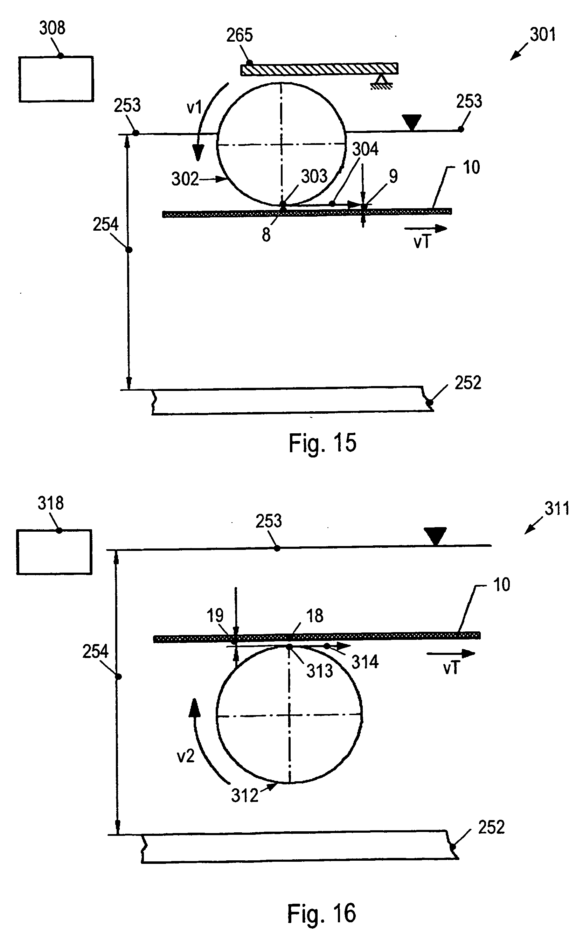

Fig. 15 ist eine teilweise geschnittene Seitenansicht eines Behandlungsabschnitts 301 einer Behandlungsstation. Der Abschnitt 301 weist eine Walze 302, eine Abstreifeinrichtung 265 und eine Antriebseinrichtung 308 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 oder in Kombination mit den Anströmdüsen einer Behandlungsstation eingesetzt werden. Elemente und Einrichtungen, die in ihrer Ausgestaltung und/oder Funktion Elementen und/oder Einrichtungen des Abschnitts 251 oder des Abschnitts 271 entsprechen und unter Bezugnahme auf Fig. 11 oder Fig. 12 beschrieben wurden, sind mit den gleichen Bezugszeichen wie in Fig. 11 oder Fig. 12 bezeichnet.

Die Walze 302 ist oberhalb der Transportebene vorgesehen und bildet einen sich über den gesamten Nutzbereich des Behandlungsgutes 10 erstreckenden Spalt zwischen der Oberfläche der Walze 302 und dem Behandlungsgut 10 aus. An beiden Seiten der Walze 302 steht die Behandlungsflüssigkeit bis zu einem Betriebsniveau 253 an. Die Antriebseinrichtung 308 treibt die Walze 302 drehend an. Entlang der Linie 303, an der die Walze 302 um die Spalthöhe 9 von dem Nutzbereich des Behandlungsgutes 10 beabstandet ist, bewegt sich die Walzenoberfläche der Walze 302 mit einer Geschwindigkeit 304, die in der Transportrichtung des Behandlungsgutes 10 gerichtet ist. Der Betrag der Geschwindigkeit 304 entspricht der Umfangsgeschwindigkeit v1 der Walze 302. Der Betrag der Umfangsgeschwindigkeit v1 ist von der Transportgeschwindigkeit vT des Behandlungsgutes 10 verschieden. Dadurch wird eine Relativgeschwindigkeit zwischen der Walze 302 und dem Behandlungsgut 10 an den Rändern des Spaltes 8 hervorgerufen.

Fig. 16 ist eine teilweise geschnittene Seitenansicht eines Behandlungsabschnitts 311 einer Behandlungsstation. Der Abschnitt 311 weist eine Walze 312 und eine Antriebseinrichtung 318 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 oder in Kombination mit den Anströmdüsen einer Behandlungsstation eingesetzt werden. Elemente und Einrichtungen, die in ihrer Ausgestaltung und/oder Funktion Elementen und/oder Einrichtungen des Abschnitts 251 oder des Abschnitts 271 entsprechen und unter Bezugnahme auf Fig. 11 oder Fig. 12 beschrieben wurden, sind mit den gleichen Bezugszeichen wie in Fig. 11 oder Fig. 12 bezeichnet.

Die Walze 312 ist unterhalb der Transportebene vorgesehen und bildet einen sich über den gesamten Nutzbereich des Behandlungsgutes 10 erstreckenden Spalt zwischen der Oberfläche der Walze 312 und dem Behandlungsgut 10 aus. Die Walze 312 ist vollständig von der Behandlungsflüssigkeit umgeben. Die Antriebseinrichtung 318 treibt die Walze 312 drehend an. Entlang der Linie 313, an der die Walze 312 um die Spalthöhe 19 von dem Nutzbereich des Behandlungsgutes 10 beabstandet ist, bewegt sich die Walzenoberfläche der Walze 312 mit einer Geschwindigkeit 314, die in der Transportrichtung des Behandlungsgutes 10 gerichtet ist. Der Betrag der Geschwindigkeit 314 entspricht der Umfangsgeschwindigkeit v2 der Walze 312. Der Betrag der Umfangsgeschwindigkeit v2 ist von der Transportgeschwindigkeit vT des Behandlungsgutes 10 verschieden. Dadurch wird eine Relativgeschwindigkeit zwischen der Walze 312 und dem Behandlungsgut 10 an den Rändern des Spaltes 18 hervorgerufen.

Bei weiteren Ausführungsformen kann die Walze 302 des Abschnitts 301 oder die Walze 312 des Abschnitts 311 auch derart drehend angetrieben werden, dass sich die Walze 302 bzw. 312 entlang der Linie 303 bzw. 313 einen entgegen der Transportrichtung des Behandlungsgutes 10 gerichtete Geschwindigkeitsvektor aufweist. Insbesondere bei Behandlungsgut mit hoher Eigensteifigkeit kann eine derartige Ausgestaltung eingesetzt werden.

Bei weiteren Ausführungsformen kann ein Paar von entlang der Transportrichtung gegeneinander versetzten Walze als Behandlungsorgan vorgesehen sein. Derartige Behandlungsorgane können insbesondere zur Behandlung von Durchgangslöchern eingesetzt werden.

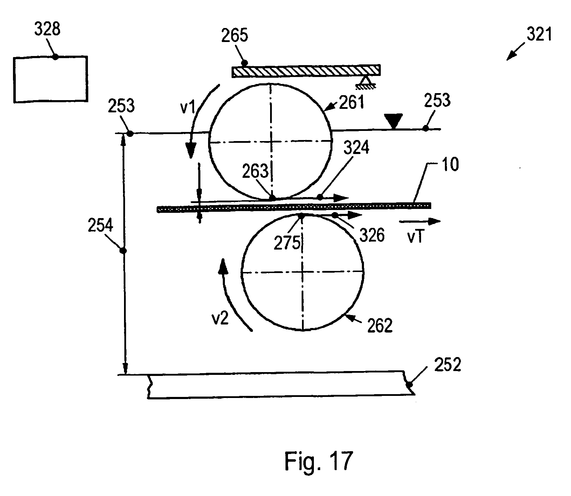

Fig. 17 ist eine teilweise geschnittene Seitenansicht eines Behandlungsabschnitts 321 einer Behandlungsstation. Der Abschnitt 291 weist ein Paar von Walzen 261, 262, eine Abstreifeinrichtung 265 und eine Antriebseinrichtung 328 auf. Diese Elemente können zur Förderung des Stoffaustauschs an der Oberfläche des Behandlungsgutes beispielsweise anstelle der Anströmdüsen 206, 207 der Behandlungsstation 200 von Fig. 18 oder in Kombination mit den Anströmdüsen einer Behandlungsstation eingesetzt werden. Elemente und Einrichtungen, die in ihrer Ausgestaltung und/oder Funktion Elementen und/oder Einrichtungen des Abschnitts 251 oder des Abschnitts 271 entsprechen und unter Bezugnahme auf Fig. 11 oder Fig. 12 beschrieben wurden, sind mit den gleichen Bezugszeichen wie in Fig. 11 oder Fig. 12 bezeichnet.

Die oberhalb der Transportebene vorgesehene Walze 261 und die unterhalb der Transportebene vorgesehene Walze 262 sind in Transportrichtung gegeneinander versetzt angeordnet. Da die Anordnung der Walzen nicht spiegelsymmetrisch bezüglich der Transportebene ist, lassen sich Durchgangslöcher gut behandeln.

Die Antriebseinrichtung 328 treibt die Walzen 261, 262 so an, dass sie gegensinnig rotieren. Entlang der Linie 263, an der die Walze 261 um die Spalthöhe 9 von dem Nutzbereich des Behandlungsgutes 10 beabstandet ist, bewegt sich die Walzenoberfläche der Walze 261 mit einer Geschwindigkeit 324, die in der Transportrichtung des Behandlungsgutes 10 gerichtet ist. Entlang der Linie 275, an der die Walze 262 um die Spalthöhe des Spaltes zwischen der Walze 262 und dem Behandlungsgut von dem Nutzbereich des Behandlungsgutes 10 beabstandet ist, bewegt sich die Walzenoberfläche der Walze 262 mit einer Geschwindigkeit 326, die ebenfalls in der Transportrichtung des Behandlungsgutes 10 gerichtet ist.

Der Betrag der Geschwindigkeit 324 entspricht der Umfangsgeschwindigkeit v1 der Walze 261. Der Betrag der Geschwindigkeit 326 entspricht der Umfangsgeschwindigkeit v2 der Walze 262. Wenigstens eine der Umfangsgeschwindigkeiten v1 und v2 ist von der Transportgeschwindigkeit vT des Behandlungsgutes 10 verschieden. Dadurch wird eine Relativgeschwindigkeit zwischen der entsprechenden Walze und dem Behandlungsgut hervorgerufen, die den Stoffaustausch an der Oberfläche des Behandlungsgutes fördert.

Bei den unter Bezugnahme auf die Figuren beschriebenen Vorrichtungen kann der Betrag der Relativgeschwindigkeit zwischen der Walze und dem Behandlungsgut am Spalt einen Betrag im Intervall von 0,1 bis 20 m/s, insbesondere im Intervall von 0,2 bis 10 m/s, insbesondere im Intervall von 0,5 bis 5 m/s aufweisen.

Wie unter Bezugnahme auf Fig. 11-14 und 17 beschrieben wurde, kann ein Paar von Walzen, die an gegenüberliegenden Seiten der Transportebene vorgesehen sind, als Behandlungsorgan in einer Behandlungsstation einer Durchlaufanlage eingesetzt werden. Bei Ausführungsformen können die zwei Walzen gleichsinnig drehend angetrieben werden. In diesem Fall kann insbesondere die unter der Transportebene angeordnete Walze derart angetrieben werden, dass ihre Umfangsgeschwindigkeit entlang der Linie, die um die Spalthöhe von dem Nutzbereich des Behandlungsgutes beabstandet ist, in Transportrichtung zeigt. Bei weiteren Ausführungsformen können die zwei Walzen gegensinnig drehend angetrieben werden. Die Antriebseinrichtung kann so ausgebildet sein, dass wahlweise eine gleichsinnige oder gegensinnige Drehung der Walzen hervorgerufen wird.

Bei den verschiedenen unter Bezugnahme auf Fig. 11-14 und 17 beschriebenen Ausführungsformen können die Umfangsgeschwindigkeit v1 der oberhalb der Transportebene angeordneten Walze und die Umfangsgeschwindigkeit v2 der unterhalb der Transportebene angeordneten Walze betragsmäßig gleich sein. Bei weiteren Ausführungsformen ist v1>v2, insbesondere v1>>v2, oder v1<v2, insbesondere v1 «v2. Insbesondere kann v2 gleich dem Betrag der Transportgeschwindigkeit des Behandlungsgutes, vT, ± 20% sein.

Bei den verschiedenen unter Bezugnahme auf Fig. 9-17 beschriebenen Vorrichtungen kann die Oberfläche der Walze jeweils zylinderförmig sein. Die Oberflächen können als Zylinderflächen ohne Öffnungen ausgebildet sein. Die Oberflächen können insbesondere undurchlässig für die Behandlungsflüssigkeit sein. Die Oberflächen der Walzen sind vorteilhaft zylinderförmig und erstrecken sich über den gesamten Nutzbereich des Behandlungsgutes, so dass ein sich kontinuierlich zwischen den Randbereichen erstreckender Spalt ausgebildet ist. Bei weiteren Ausführungsformen können mehrere walzenförmige Teilelemente kombiniert werden, um abschnittsweise einen sich über den Nutzbereich erstreckenden Spalt auszubilden.

Zahlreiche Abwandlungen der in den Figuren dargestellten und detailliert beschriebenen Ausführungsbeispiele können bei weiteren Ausführungsbeispielen realisiert werden.

Während unter Bezugnahme auf Fig. 11-17 Vorrichtungen beschrieben wurden, bei denen eine Abstreifeinrichtung in einer Umgebung einer Walze vorgesehen ist, die oberhalb der Transportebene vorgesehen ist, kann bei weiteren Ausführungsformen ein feststehendes Element auch in einer Umgebung der unterhalb der Transportebene vorgesehenen Walze vorgesehen sein. Das feststehende Element kann beispielsweise als Leiste ausgebildet sein. Die Leiste beeinflusst das Strömungsfeld in einer Umgebung der Walze. Die Leiste kann relativ zu der Walze verstellt werden.

Bei allen hier beschriebenen Ausführungsformen kann eine Walze bzw. können die Walzen als Elektroden für eine elektrolytische Behandlung ausgestaltet sein. Sie können insbesondere als inerte Anoden ausgebildet sein.

Bei allen hier beschriebenen Ausführungsformen kann eine Walze bzw. können die Walzen eine Oberfläche aufweisen, die innerhalb von Bearbeitungstoleranzen glatt ist. Bei weiteren Ausführungsformen kann die Oberfläche der Walze bzw. der Walzen auch eine Struktur aufweisen.

Bei allen hier beschriebenen Ausführungsformen kann eine Walze bzw. können die Walzen auch so angeordnet sein, dass die Achse der Walze einen von 90° verschiedenen Winkel mit der Transportrichtung einschließt.

Während bei verschiedenen Ausführungsbeispielen Rückhalteflächen beschrieben wurden, die sich in Breitenrichtung des Behandlungsgutes im Wesentlichen in gleicher Höhe quer zum Behandlungsgut erstrecken, kann die spaltbildende Rückhaltefläche auch so ausgebildet sein, dass sich der Querschnitt des Spaltes, insbesondere die Spalthöhe, in der Breitenrichtung des Behandlungsgutes verändert. Beispielsweise kann die Rückhaltefläche in Breitenrichtung des Behandlungsgutes konkav sein, so dass der ausgebildete Spalt, als Funktion einer Position in Breitenrichtung des Behandlungsgutes, in der Mitte des Behandlungsgutes höher als an den Rändern ist.

Während die verschiedenen Ausführungsbeispiele insbesondere bei Behandlungsanlagen eingesetzt werden können, in denen das Behandlungsgut kontinuierlich und in einer horizontalen Transportebene transportiert wird, können Ausführungsbeispiele auch bei Anlagen eingesetzt werden, in denen das Behandlungsgut in einer vertikalen Transportebene transportiert wird. Beispielsweise kann eine Kombination aus spaltbildender Rückhaltefläche und Anströmeinrichtung auch zum Anstauen von Flüssigkeit verwendet werden, wenn das Behandlungsgut in einer vertikalen Transportebene transportiert wird. Eine oder mehrere Walzen, deren Achse in vertikaler Richtung zeigt bzw. zeigen, kann bzw. können als Behandlungsorgan eingesetzt werden, wenn das Behandlungsgut in einer vertikalen Transportebene transportiert wird.

Während im Kontext von Ausführungsbeispielen die Verwendung von Walzen, die von dem gesamten Nutzbereich des Behandlungsgutes beabstandet sind, in einem Ein- oder Auslaufbereich einer Behandlungsstation oder als Behandlungsorgan beschrieben wurden, kann bei weiteren Ausführungsformen eine Behandlungsstation sowohl wenigstens eine drehend angetriebene Walze als Behandlungsorgan, wie es unter Bezugnahme auf Fig. 11-17 beschrieben wurde, als auch wenigstens eine drehend angetriebene Walze in einem Ein-oder Auslaufbereich, wie unter Bezugnahme auf Fig. 1-10 beschrieben, aufweisen.

Die Vorrichtungen und Verfahren nach den verschiedenen Ausführungsbeispielen können beispielsweise bei der Herstellung von Leiterplatten, wie gedruckten Leiterplatten, eingesetzt werden, ohne dass ihre Anwendung darauf beschränkt ist.

### BEZUGSZEICHENLISTE

- 1: Vorrichtung zum Entfernen von Behandlungsflüssigkeit
- 2: Walze
- 3: weitere Walze
- 4: Rückhaltefläche
- 5, 6: erhöhter Randabschnitt
- 7: Welle
- 8: Spalt
- 9: minimale Spalthöhe
- 10: Behandlungsgut
- 11: Nutzbereich
- 12: Randbereich
- 14: weitere Rückhaltefläche
- 15, 16: erhöhter Randabschnitt
- 17: Welle
- 18: weiterer Spalt
- 19: minimale Spalthöhe
- 20: Transportrichtung
- 21: Behandlungsflüssigkeit
- 22: Flüssigkeitsniveau
- 23: Behandlungsflüssigkeit
- 24: Flüssigkeitsniveau
- 25, 26: Drehrichtung
- 31: Vorrichtung zum Entfernen von Behandlungsflüssigkeit
- 32: Anströmeinrichtung
- 33: Fluidstrom
- 34: Behandlungsflüssigkeit
- 41: Auslaufbereich
- 42: Behandlungsbereich
- 43,44, 45: Vorrichtung zum Entfernen von Behandlungsflüssigkeit
- 46: Boden
- 47, 48: Wehr
- 51, 52: Walze
- 53, 55: Walze
- 54, 56: Anströmeinrichtung
- 57, 59: Walze
- 58, 60: Anströmeinrichtung
- 61: Öffnung
- 71, 72: Flüssigkeitsniveau
- 73: Behandlungsflüssigkeit
- 74: Niveauunterschied
- 81: Auslaufbereich
- 82: Behandlungsbereich
- 83: Vorrichtung zum Entfernen von Behandlungsflüssigkeit
- 84-86: Walze
- 91, 92: Flüssigkeitsniveau
- 93: Behandlungsflüssigkeit
- 94: Pumpe
- 95: Flüssigkeitsstrom
- 96: Öffnung
- 97: Niveauunterschied
- 101: Vorrichtung zum Entfernen von Behandlungsflüssigkeit
- 102: Walze
- 103: weitere Walze
- 104: Rückhaltefläche
- 105: zurückgesetzter Randabschnitt
- 106: weitere Rückhaltefläche
- 107: zurückgesetzter Randabschnitt
- 108, 109: Halteschiene
- 111: Vorrichtung zum Entfernen von Behandlungsflüssigkeit
- 112, 113: Einsatz
- 114, 117: Seitenfläche
- 115, 118: Spalt
- 116, 119: Abschrägung
- 131: Behandlungsstation
- 132-135: Walze
- 136: Flüssigkeitsniveau
- 141-148: Drehrichtung
- 200: Behandlungsstation
- 201: Innenbehälter
- 202: Außenbehälter
- 203: Behandlungsgut
- 204: Transportrichtung
- 206, 207: Anströmdüse
- 208: Behandlungsflüssigkeit
- 209: Niveau im Außenbehälter
- 210: Pumpe
- 211, 212, 214, 216: Transportwalzenpaar
- 213, 215: Abquetschwalzenpaar
- 221: Auslaufbereich
- 222: Boden
- 223, 225: Flüssigkeitsniveau
- 224, 226: Höhe
- 227: Wehr
- 228, 229: Walzenoberfläche
- 231, 232: Walze
- 233: Linie auf Walzenoberfläche
- 234: Geschwindigkeit
- 235: Abstreifeinrichtung
- 236: Anströmeinrichtung
- 237: Fluidstrom
- 238: Antriebseinrichtung
- 241: Auslaufbereich
- 248: Antriebseinrichtung
- 251: Behandlungsabschnitt
- 252: Boden
- 253: Betriebsniveau
- 254: Höhe
- 258, 259: Walzenoberfläche
- 261, 262: Walze
- 263: Linie auf Walzenoberfläche
- 264: Geschwindigkeit
- 265: Abstreifeinrichtung
- 266: Abstand
- 268: Antriebseinrichtung
- 271: Behandlungsabschnitt
- 274: Geschwindigkeit
- 275: Linie auf Walzenoberfläche
- 276: Geschwindigkeit
- 278: Antriebseinrichtung
- 281: Behandlungsabschnitt
- 284, 286: Geschwindigkeit
- 288: Antriebseinrichtung
- 291: Behandlungsabschnitt
- 294, 296: Geschwindigkeit
- 298: Antriebseinrichtung
- 301: Behandlungsabschnitt
- 302: Walze
- 303: Linie auf Walzenoberfläche
- 304: Geschwindigkeit
- 308: Antriebseinrichtung
- 311: Behandlungsabschnitt
- 312: Walze
- 313: Linie auf Walzenoberfläche
- 314: Geschwindigkeit
- 318: Antriebseinrichtung
- 321: Behandlungsabschnitt
- 324, 326: Geschwindigkeit
- 328: Antriebseinrichtung

## Patentansprüche

1. Verfahren zum Behandeln eines flächigen Behandlungsgutes (10), das durch eine Anlage zur elektrolytischen oder nasschemischen Behandlung des Behandlungsgutes (10) transportiert wird,
wobei das Behandlungsgut (10) in einer Behandlungsstation der Anlage einer das Behandlungsgut (10) überdeckenden Behandlungsflüssigkeit (21) ausgesetzt wird, wobei in der Behandlungsstation eine Walze (2, 3; 51, 52, 53, 55, 57, 59; 84, 85; 102, 103; 132-135; 231, 232; 261, 262; 302; 312) mit einer Walzenoberfläche (4, 14; 104, 106; 228, 229; 258, 259) derart angeordnet ist, dass die Walzenoberfläche (4, 14; 104, 106; 228, 229; 258, 259) wenigstens von einem Nutzbereich (11) des Behandlungsgutes (10), der sich kontinuierlich zwischen Randbereichen (12) des Behandlungsgutes (10) erstreckt, beabstandet ist, so dass zwischen der Walzenoberfläche (4, 14; 104, 106; 228, 229; 258, 259) und dem Nutzbereich des Behandlungsgutes (10) ein Spalt (8, 18) freibleibt,
wobei die Walze (2, 3; 51, 52, 53, 55, 57, 59; 84, 85; 102, 103; 132-135; 231, 232; 261, 262; 302; 312) derart drehend angetrieben wird, dass an dem Spalt (8, 18) eine Relativgeschwindigkeit zwischen der Walzenoberfläche (4, 14; 104, 106; 228, 229; 258, 259) und einer Oberfläche des Behandlungsgutes (10) hervorgerufen wird,
**dadurch gekennzeichnet,**
**dass** die Behandlungsflüssigkeit (21) in einem Behandlungsbereich der Behandlungsstation bis zu einem Betriebsniveau (253) angestaut ist, und
**dass** die Walzenoberfläche (4, 14; 104, 106; 228, 229; 258, 259) wenigstens teilweise in der bis zu dem Betriebsniveau (253) angestauten Behandlungsflüssigkeit (21) angeordnet ist.

2. Verfahren nach Anspruch 1,
wobei die Walze (2, 3; 51, 52, 53, 55, 57, 59; 84, 85; 102, 103; 132-135; 231, 232; 261, 262; 302; 312) so angetrieben wird, dass eine Umfangsgeschwindigkeit (v1, v2) der Walzenoberfläche von einer Transportgeschwindigkeit (vT) des Behandlungsgutes (10) betragsmäßig verschieden, insbesondere größer als die Transportgeschwindigkeit (vT), ist.

3. Verfahren nach einem der vorhergehenden Ansprüche,
wobei mit einer Abstreifeinrichtung (235; 265) Behandlungsflüssigkeit von der Walze (231; 261; 302) entfernt wird.

4. Verfahren nach Anspruch 3,
wobei die Abstreifeinrichtung (235; 265) verstellt wird, um eine Menge der von der Walze (231; 261; 302) entfernten Behandlungsflüssigkeit einzustellen.

5. Verfahren nach einem der vorhergehenden Ansprüche,
wobei die Walze (261, 262; 302; 312) als Behandlungsorgan in der Behandlungsstation vorgesehen ist.

6. Verfahren nach einem der vorhergehenden Ansprüche,
wobei an in Transportrichtung entgegengesetzten Seiten der Walze (261; 302) die Behandlungsflüssigkeit (21) bis zu dem Betriebsniveau (253) der Behandlungsstation ansteht oder wobei die Walze (262; 312) vollständig unterhalb des Betriebsniveaus (253) der Behandlungsstation angeordnet ist.

7. Verfahren nach einem der vorhergehenden Ansprüche,
wobei in der Behandlungsstation eine weitere Walze (3; 52, 55, 59; 85; 103; 133, 135; 232; 262) mit einer weiteren Walzenoberfläche (14) derart positioniert ist, dass ein weiterer Spalt (18) zwischen dem Nutzbereich (11) des Behandlungsgutes (10) und der weiteren Walzenoberfläche (14) freibleibt,
wobei die Walze (2; 51, 53, 57; 84; 102; 132, 134; 231; 261) und die weitere Walze (3; 52, 55, 59; 85; 103; 133, 135; 232; 262) an entgegengesetzten Seiten einer Transportebene des Behandlungsgutes (10) positioniert sind.

8. Behandlungsstation zum Behandeln eines flächigen Behandlungsgutes (10) für eine Anlage zur elektrolytischen oder nasschemischen Behandlung des Behandlungsgutes (10), wobei die Behandlungsstation derart eingerichtet ist, dass im Betrieb eine Behandlungsflüssigkeit (21) das zu behandelnde Behandlungsgut (10) überdeckt, umfassend
eine Walze (2, 3; 51, 52, 53, 55, 57, 59; 84, 85; 102, 103; 132-135; 231, 232; 261, 262; 302; 312) mit einer Walzenoberfläche (4, 14; 104, 106; 228, 229; 258, 259), welche derart angeordnet ist, dass die Walzenoberfläche (4, 14; 104, 106; 228, 229; 258, 259) wenigstens von einem Nutzbereich (11) des Behandlungsgutes (10), der sich kontinuierlich zwischen Randbereichen (12) des Behandlungsgutes (10) erstreckt, beabstandet ist, so dass zwischen der Walzenoberfläche (4, 14; 104, 106; 228, 229; 258, 259) und dem Nutzbereich (11) des Behandlungsgutes (10) ein Spalt (8, 18) freibleibt, und
eine Antriebseinrichtung (238; 248; 268; 278; 288; 298; 308; 318; 328), die eingerichtet ist, um die Walze (2, 3; 51, 52, 53, 55, 57, 59; 84, 85; 102, 103; 132-135; 231, 232; 261, 262; 302; 312) derart drehend anzutreiben, dass an dem Spalt (8, 18) eine Relativgeschwindigkeit zwischen der Walzenoberfläche (4, 14; 104, 106; 228, 229; 258, 259) und der Oberfläche des Behandlungsgutes (10) resultiert,
**dadurch gekennzeichnet,**
**dass** die Behandlungsflüssigkeit (21) in einem Behandlungsbereich der Behandlungsstation bis zu einem Betriebsniveau (253) angestaut ist, und
**dass** die Walzenoberfläche (4, 14; 104, 106; 228, 229; 258, 259) wenigstens teilweise in der bis zu dem Betriebsniveau (253) angestauten Behandlungsflüssigkeit angeordnet ist.

9. Behandlungsstation nach Anspruch 8, umfassend
eine weitere Walze (3; 52, 55, 59; 85; 103; 133, 135; 232; 262) mit einer weiteren Walzenoberfläche (14), welche derart positioniert ist, dass ein weiterer Spalt (18) zwischen dem Nutzbereich (11) des Behandlungsgutes (10) und der weiteren Walzenoberfläche (14) freibleibt,
wobei die Walze (2; 51, 53, 57; 84; 102; 132, 134; 231; 261) und die weitere Walze (3; 52, 55, 59; 85; 103; 133, 135; 232; 262) an entgegengesetzten Seiten einer Transportebene des Behandlungsgutes (10) angeordnet sind.

10. Behandlungsstation nach Anspruch 8 oder Anspruch 9,
welche zur Durchführung des Verfahrens nach einem der Ansprüche 1-7 eingerichtet ist.

11. Anlage zum Behandeln eines flächigen Behandlungsgutes (10), umfassend die Behandlungsstation (221; 241; 251; 271; 281; 291; 301; 311) nach einem der Ansprüche 8-10.

12. Verfahren zum Herstellen einer Leiterplatte, umfassend
Behandeln eines Materials (10) zur Herstellung der Leiterplatte mit dem Verfahren nach einem der Ansprüche 1-7.

## Claims

1. Method for treating a planar material to be treated (10) which is transported through an assembly for the electrolytic or wet-chemical treatment of the material to be treated (10),
wherein, in a treatment station of the assembly, the material to be treated (10) is subjected to a treatment liquid (21) covering the material to be treated (10),
wherein, in the treatment station, a roll (2, 3; 51, 52, 53, 55, 57, 59; 84, 85; 102, 103; 132-135; 231, 232; 261, 262; 302; 312) having a roll surface (4, 14; 104, 106; 228, 229; 258, 259) is arranged such that the roll surface (4, 14; 104, 106; 228, 229; 258, 259) is spaced apart at least from a useful region (11) of the material to be treated (10) which extends continuously between edge regions (12) of the material to be treated (10) so that a gap (8, 18) remains between the roll surface (4, 14; 104, 106; 228, 229; 258, 259) and the useful region of the material to be treated (10),
the roll (2, 3; 51, 52, 53, 55, 57, 59; 84, 85; 102, 103; 132-135; 231, 232; 261, 262; 302; 312) being driven rotatably so that at the gap (8, 18) a relative speed is generated between the roll surface (4, 14; 104, 106; 228, 229; 258, 259) and a surface of the material to be treated (10),
**characterized in that**
the treatment liquid (21) is accumulated up to an operating level (253) in a treatment region of the treatment station, and
the roll surface (4, 14; 104, 106; 228, 229; 258, 259) is arranged at least partially in the treatment liquid (21) which is accumulated up to the operating level (253).

2. Method according to Claim 1,
wherein the roll (2, 3; 51, 52, 53, 55, 57, 59; 84, 85; 102, 103; 132-135; 231, 232; 261, 262; 302; 312) is driven such that a circumferential speed (v1, v2) of the roll surface is different in modulus from a transport speed (vT) of the material to be treated (10), in particular is greater than the transport speed (vT).

3. Method according to any one of the preceding claims,
wherein treatment liquid is removed from the roll (231; 261; 302) by a stripping device (235; 265).

4. Method according to Claim 3,
wherein the stripping device (235; 265) is adjusted to set an amount of the treatment liquid which is removed from the roll (231; 261; 302).

5. Method according to any one of the preceding claims,
wherein the roll (261, 262; 302; 312) is provided as a treatment member in the treatment station.

6. Method according to any one of the preceding claims,
wherein the treatment liquid (21) comes into contact with sides of the roll (261; 302) which are opposed in the transport direction up to the operating level (253) of the treatment station, or wherein the roll (262; 312) is arranged completely below the operating level (253) of the treatment station.

7. Method according to any one of the preceding claims,
wherein a further roll (3; 52, 55, 59; 85; 103; 133, 135; 232; 262) having a further roll surface (14) is positioned in the treatment station so that a further gap (18) remains between the useful region (11) of the material to be treated (10) and the further roll surface (14), the roll (2; 51, 53, 57; 84; 102; 132, 134; 231; 261) and the further roll (3; 52, 55, 59; 85; 103; 133, 135; 232; 262) being positioned on opposing sides of a transport plane of the material to be treated (10).

8. Treatment station for treating a planar material to be treated (10) for an assembly for the electrolytic or wet-chemical treatment of the material to be treated (10), the treatment station being configured such that a treatment liquid (21) covers the material (10) to be treated in operation, comprising
a roll (2, 3; 51, 52, 53, 55, 57, 59; 84, 85; 102, 103; 132-135; 231, 232; 261, 262; 302; 312) having a roll surface (4, 14; 104, 106; 228, 229; 258, 259) which is arranged such that the roll surface (4, 14; 104, 106; 228, 229; 258, 259) is spaced apart from at least a useful region (11) of the material to be treated (10) which extends continuously between edge regions (12) of the material to be treated (10) so that a gap (8, 18) remains between the roll surface (4, 14; 104, 106; 228, 229; 258, 259) and the useful region (11) of the material to be treated (10), and a drive device (238; 248; 268; 278; 288; 298; 308; 318; 328) which is configured to drive the roll (2, 3; 51, 52, 53, 55, 57, 59; 84, 85; 102, 103; 132-135; 231, 232; 261, 262; 302; 312) rotatably such that at the gap (8, 18) a relative speed results between the roll surface (4, 14; 104, 106; 228, 229; 258, 259) and the surface of the material to be treated (10),
**characterized in that**
the treatment liquid (21) is accumulated up to an operating level (253) in a treatment region of the treatment station, and
the roll surface (4, 14; 104, 106; 228, 229; 258, 259) is arranged at least partially in the treatment liquid which is accumulated up to the operating level (253).

9. Treatment station according to Claim 8, comprising a further roll (3; 52, 55, 59; 85; 103; 133, 135; 232; 263) having a further roll surface (14) which is positioned such that a further gap (18) remains between the useful region (11) of the material to be treated (10) and the further roll surface (14),
the roll (2; 51, 53, 57; 84; 102; 132, 134; 231; 261) and the further roll (3; 52, 55, 59; 85; 103; 133, 135; 232; 262) being arranged on opposing sides of a transport plane of the material to be treated (10).

10. Treatment station according to Claim 8 or Claim 9, which is configured to perform the method according to any one of Claims 1-7.

11. Assembly for treating a planar material to be treated (10), comprising the treatment station (221; 241; 251; 271; 281; 291; 301; 311) according to any one of Claims 8-10.

12. Method for producing a circuit board, comprising
treating a material to be treated (10) for producing the circuit board by the method according to any one of Claims 1-7.

## Revendications

1. Procédé servant à traiter un produit à traiter (10) plat, qui est transporté à travers une installation servant au traitement électrolytique ou par voie chimique humide du produit à traiter (10),
sachant que le produit à traiter (10) est exposé, dans une station de traitement de l'installation, à un liquide de traitement (21) recouvrant le produit à traiter (10),
sachant qu'un cylindre (2, 3 ; 51, 52, 53, 55, 57, 59 ; 84, 85 ; 102, 103 ; 132 - 135 ; 231, 232 ; 261, 262 ; 302 ; 312) présentant une surface de cylindre (4, 14 ; 104, 106 ; 228, 229 ; 258, 259) est disposé dans la station de traitement de telle manière que la surface de cylindre (4, 14 ; 104, 106 ; 228, 229 ; 258, 259) est espacée au moins d'une zone utile (11) du produit à traiter (10), laquelle s'étend en continu entre des zones de bord (12) du produit à traiter (10) de sorte qu'une fente (8, 18) reste dégagée entre la surface de cylindre (4, 14 ; 104, 106 ; 228, 229 ; 258, 259) et la zone utile du produit à traiter (10), sachant que le cylindre (2, 3 ; 51, 52, 53, 55, 57, 59 ; 84, 85 ; 102, 103 ; 132 - 135 ; 231, 232 ; 261, 262 ; 302 ; 312) est entraîné en rotation de telle manière que cela donne lieu à une vitesse relative entre la surface de cylindre (4, 14 ; 104, 106 ; 228, 229 ; 258, 259) et une surface du produit à traiter (10) au niveau de la fente (8, 18),
**caractérisé en ce**
**que** le liquide de traitement (21) est stocké dans une zone de traitement de la station de traitement jusqu'à un niveau de fonctionnement (253), et
en ce que la surface de cylindre (4, 14 ; 104, 106 ; 228, 229 ; 258, 259) est disposée au moins en partie dans le liquide de traitement (21) stocké jusqu'au niveau de fonctionnement (253).

2. Procédé selon la revendication 1,
sachant que le cylindre (2, 3 ; 51, 52, 53, 55, 57, 59 ; 84, 85 ; 102, 103 ; 132 - 135 ; 231, 232 ; 261, 262 ; 302 ; 312) est entraîné de telle manière qu'une vitesse périphérique (v1, v2) de la surface de cylindre diffère en termes de valeur d'une vitesse de transport (vT) du produit à traiter (10), en particulier est supérieure à la vitesse de transport (vT).

3. Procédé selon l'une quelconque des revendications précédentes,
sachant que le liquide de traitement est supprimé du cylindre (231 ; 261 ; 302) à l'aide d'un système de raclage (235 ; 265).

4. Procédé selon la revendication 3,
sachant que le système de raclage (235 ; 265) est déplacé pour ajuster une quantité du liquide de traitement supprimée du cylindre (231 ; 261 ; 302).

5. Procédé selon l'une quelconque des revendications précédentes,
sachant que le cylindre (261, 262 ; 302, 312) est prévu en tant qu'organe de traitement dans la station de traitement.

6. Procédé selon l'une quelconque des revendications précédentes,
sachant que le liquide de traitement (21) stagne jusqu'au niveau de fonctionnement (253) de la station de traitement au niveau de côtés, opposés dans le sens de transport, du cylindre (261 ; 302) ou sachant que le cylindre (262, 312) est disposé complètement en dessous du niveau de fonctionnement (253) de la station de traitement.

7. Procédé selon l'une quelconque des revendications précédentes,
sachant qu'un autre cylindre (3 ; 52, 55, 59 ; 85 ; 103 ; 133, 135 ; 232 ; 262) présentant une autre surface de cylindre (14) est positionné dans la station de traitement de telle manière qu'une autre fente (18) entre la zone utile (11) du produit à traiter (10) et l'autre surface de cylindre (14) reste dégagée,
sachant que le cylindre (2 ; 51, 53, 57 ; 84 ; 102 ; 132, 134 ; 231 ; 261) et l'autre cylindre (3 ; 52, 55, 59 ; 85 ; 103 ; 133, 135 ; 232 ; 262) sont positionnés au niveau de côtés opposés d'un plan de transport du produit à traiter (10).

8. Station de traitement servant à traiter un produit à traiter (10) plat destinée à une installation servant au traitement électrolytique ou par voie chimique humide du produit à traiter (10), sachant que le station de traitement est mise au point de telle manière qu'en fonctionnement un liquide de traitement (21) recouvre le produit à traiter (10) devant être traité,
comprenant
un cylindre (2, 3 ; 51, 52, 53, 55, 57, 59 ; 84, 85 ; 102, 103 ; 132-135 ; 231, 232 ; 261, 262 ; 302 ; 312) présentant une surface de cylindre (4, 14 ; 104, 106 ; 228, 229 ; 258, 259), lequel est disposé de telle manière que la surface de cylindre (4, 14 ; 104, 106 ; 228, 229 ; 258, 259) est espacée au moins d'une zone utile (11) du produit à traiter (10), laquelle s'étend en continu entre des zones de bord (12) du produit à traiter (10), de sorte qu'une fente (8, 18) reste dégagée entre la surface de cylindre (4, 14 ; 104, 106 ; 228, 229 ; 258, 259) et la zone utile (11) du produit à traiter (10), et
un système d'entraînement (238 ; 248 ; 268 ; 278 ; 288 ; 298 ; 308 ; 318 ; 328) qui est mis au point pour entraîner en rotation le cylindre (2, 3 ; 51, 52, 53, 55, 57, 59 ; 84, 85 ; 102, 103 ; 132-135 ; 231, 232 ; 261, 262 ; 302 ; 312) de telle manière qu'il résulte au niveau de la fente (8, 18), une vitesse relative entre la surface de cylindre (4, 14 ; 104, 106 ; 228, 229 ; 258, 259) et la surface du produit à traiter (10),
**caractérisée en ce**
**que** le liquide de traitement (21) est stocké dans une zone de traitement de la station de traitement jusqu'à un niveau de fonctionnement (253), et
en ce que la surface de cylindre (4, 14 ; 104, 106 ; 228, 229 ; 258, 259) est disposée au moins en partie dans le liquide de traitement stocké jusqu'au niveau de fonctionnement (253).

9. Station de traitement selon la revendication 8, comprenant
un autre cylindre (3, 52, 55, 59 ; 85 ; 103 ; 133, 135 ; 232 ; 262) présentant une autre surface de cylindre (14), qui est positionné de telle manière qu'une autre fente (18) entre la zone utile (11) du produit à traiter (10) et l'autre surface de cylindre (14) reste dégagée,
sachant que le cylindre (2 ; 51, 53, 57 ; 84 ; 102 ; 132, 134 ; 231 ; 261) et l'autre cylindre (3 ; 52, 55, 59 ; 85 ; 103 ; 133, 135 ; 232 ; 262) sont disposés au niveau de côtés opposés d'un plan de transport du produit à traiter (10).

10. Station de traitement selon la revendication 8 ou la revendication 9,
laquelle est mise au point pour exécuter le procédé selon l'une quelconque des revendications 1 à 7.

11. Installation servant à traiter un produit à traiter (10) plat, comprenant la station de traitement (221 ; 241 ; 251 ; 271 ; 281 ; 291 ; 301 ; 311) selon l'une quelconque des revendications 8 à 10.

12. Procédé servant à fabriquer une carte de circuit imprimé, comprenant
le traitement d'un matériau (10) servant à fabriquer la carte de circuit imprimé à l'aide du procédé selon l'une quelconque des revendications 1 à 7.
